(19) Europäisches Patentamt
European Patent Office
Office européen des brevets

(11) **EP 4 075 152 B1**

(12) **EUROPEAN PATENT SPECIFICATION**

(45) Date of publication and mention
of the grant of the patent:
**25.06.2025   Bulletin 2025/26**

(21) Application number: **20899133.1**

(22) Date of filing: **04.06.2020**

(51) International Patent Classification (IPC):
**G01R 29/08** *(2006.01)*     **H01Q 3/26** *(2006.01)*
**G01S 7/02** *(2006.01)*

(52) Cooperative Patent Classification (CPC):
**H01Q 13/0275; G01S 7/03; H01Q 3/2682;**
G01R 29/0878; G01S 2013/0263; Y02A 90/10

(86) International application number:
**PCT/JP2020/022185**

(87) International publication number:
**WO 2021/117269 (17.06.2021 Gazette 2021/24)**

(54) **PHASED-ARRAY ANTENNA DEVICE**

PHASENGESTEUERTE ANTENNENVORRICHTUNG

DISPOSITIF D'ANTENNE RÉSEAU À COMMANDE DE PHASE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.12.2019   JP 2019224449**

(43) Date of publication of application:
**19.10.2022   Bulletin 2022/42**

(73) Proprietor: **Japan Aerospace Exploration Agency
Tokyo 182-8522 (JP)**

(72) Inventors:
• **MAEDA Takashi**
  **Chofu-shi, Tokyo 182-8522 (JP)**
• **TOMII Naoya**
  **Chofu-shi, Tokyo 182-8522 (JP)**
• **UEMATSU Akihisa**
  **Chofu-shi, Tokyo 182-8522 (JP)**
• **INAOKA Kazuya**
  **Chofu-shi, Tokyo 182-8522 (JP)**
• **KAWAGUCHI Noriyuki**
  **Chofu-shi, Tokyo 182-0025 (JP)**

(74) Representative: **Betten & Resch
Patent- und Rechtsanwälte PartGmbB
Maximiliansplatz 14
80333 München (DE)**

(56) References cited:
CN-A- 110 448 810     JP-A- 2007 303 855
JP-A- H0 251 074     JP-A- H09 134 113
JP-A- H09 211 045     JP-A- S61 502 075
US-A- 5 724 044

• ADRIANO CAMPSANGEL CARDAMAD.
INFANTES: "Synthesis of Large Low-
Redundancy Linear Arrays", IEEE
TRANSACTIONS ON ANTENNAS AND
PROPAGATION, vol. 49, no. 12, December 2002
(2002-12-01), XP011004157, ISSN: 0018-926X

## Description

Technical Field

The present invention mainly relates to a phased-array antenna device that receives microwaves.

Background Art

A microwave radiometer is a radiometer that passively observes the intensity of extremely weak electromagnetic waves in a microwave range radiated from the ground surface for each frequency component. An object radiates weak electromagnetic waves by blackbody radiation based on its temperature. The microwave radiometer detects the intensity of weak electromagnetic waves based on the blackbody radiation using time integration.

The applicant operates an artificial satellite equipped with a microwave radiometer disclosed in Non-Patent Literature 1 to observe the temperature of the sea surface, the salinity concentration of seawater, measurement of soil moisture, and the like from the observed luminance temperature.

Patent Literature 1 discloses the technical details of an electronic scanning microwave radiometer that enables single-area scanning of the earth surface or the like at a conical and a predetermined fixed incident angle.

Non-Patent Literature 2 discloses the technical details related to a combination of numbers that reduces the redundancy of antenna elements of a phased array antenna.

Citation List

Patent Literature

Patent Literature 1: JP H7-209359 A; US5874916

Non Patent Literature

Non Patent Literature 1: "Space utilization by artificial satellites: Global Change Observation Mission - Water "Shizuku" (GCOM-W)" Internet <http://www.jaxa.jp/projects/sat/gcom_w/>
Non Patent Literature 2: Adriano Camps, Angel Cardama, and D. Infantes, "Synthesis of Large Low-Redundancy Linear Arrays", IEEE TRANSACTIONS ON ANTENNAS AND PROPAGATION, VOL. 49, NO. 12, DECEMBER 2002, Internet <https://www.semanticscholar.org/paper/Synthesis-of-large-low-redundancy-linear-arrays-Camps-Cardama/f8a1e40005ce0491066d945d808bae0c7abd4a7b>

Summary of Invention

Technical Problem

The microwave radiometer disclosed in Non-Patent Literature 1 and mounted on an artificial satellite currently in operation is equipped with a horn antenna for each of a plurality of frequency bands, and rotationally drives a disk-shaped reflecting mirror at a speed of one rotation every 1.5 seconds. The rotating part including the reflecting mirror weighs about 250 kg. The current microwave radiometer disclosed in Non-Patent Literature 1 has the following problems.
(1) First, since a currently-used microwave radiometer performs scanning by rotating its reflecting mirror, aged deterioration of a mechanically movable component is unavoidable, which inevitably shortens the operating lifespan.
(2) Next, the currently-used microwave radiometer requires a larger reflecting mirror in order to improve the spatial resolution, but the size of the reflecting mirror is limited because the reflecting mirror needs to be rotationally driven, and the resolution has to be lowered.
(3) Furthermore, the currently-used microwave radiometer is equipped with a horn antenna for each of a plurality of frequency bands, but some observed frequencies are skipped because the receivable frequency bands of the plurality of horn antennas are narrow, resulting in excluding some frequency bands from the observation targets.
(4) In addition, the influence of radio frequency interference (RFI) due to artificial radio waves on the ground, such as broadcasting stations, mobile phones, and the like, increases year by year, and frequency bands affected as the radio communication technology advances are also shifting to higher frequencies. For these reasons, there is a concern that microwave radiometer observation will become more difficult in the near future.

A purpose of the present invention is to provide a phased-array antenna device that solves the problems, has high spatial resolution, realizes microwave observation of a broad band and high frequency resolution, and has a long operating lifespan achieved without using a mechanically movable component.

Solution to Problem

In order to solve the above problems, a phased-array antenna device in the present invention includes a first antenna element, a first preamplifier that amplifies a signal obtained from the first antenna element, a first BPF that passes only a signal in a predetermined frequency band from an output signal of the first preamplifier, and a first A/D converter that converts an output signal of the first BPF into digital data.

In addition, the phased-array antenna device in the present invention includes a first FFT that performs a Fourier transform on data output from the first A/D converter, a second antenna element arranged apart from the first antenna element by a predetermined distance, a second preamplifier that amplifies a signal obtained from the second antenna element, and a second BPF that passes only a signal in the same frequency band as the first BPF from an output signal of the second preamplifier.

Furthermore, the phased-array antenna device in the present invention includes a second A/D converter that converts an output signal of the second BPF into digital data, a second FFT that performs a Fourier transform on data output from the second A/D converter, and a first cross-spectrum calculation unit that multiplies output data of the first FFT and output data of the second FFT for the same complex frequency component after converting one of the output data of the first FFT and the output data of the second FFT into a conjugate complex number. Moreover, the phased-array antenna device in the present invention includes a clock control unit that supplies a sampling clock whose output timing is relatively shifted to the first A/D converter and the second A/D converter.

Advantageous Effects of Invention

According to the present invention, it is possible to provide a phased-array antenna device that has high spatial resolution, realizes microwave observation of a broad band and high frequency resolution, and has a long operating lifespan achieved without using a mechanically movable component.

Problems, configurations, and effects other than those described above will be clarified by the following description of an embodiment.

Brief Description of Drawings

Fig. 1 is a schematic diagram illustrating an overall configuration of a phased-array antenna device according to an embodiment of the present invention.
Fig. 2 illustrates an external perspective view of an antenna element.
Fig. 3 is a block diagram illustrating the overall configuration of the phased-array antenna device.
Fig. 4 is a schematic diagram illustrating the number of mounted cross-spectrum calculation unit groups.
Fig. 5 is a block diagram illustrating a functional configuration of one system of the phased-array antenna device.
Fig. 6 is a schematic diagram conceptually illustrating an analog signal output from a preamplifier, digital data obtained from an A/D converter, complex frequency data obtained from an FFT, and the calculation of a cross-spectrum calculation unit.
Fig. 7 is a schematic diagram conceptually illustrating a complex frequency component data group output from the cross-spectrum calculation unit and an overall image of the calculation of an addition unit.
Fig. 8 is a schematic diagram conceptually illustrating a part of the calculation of the addition unit and a form of data output by the addition unit.
Fig. 9 is a schematic diagram conceptually illustrating the calculation of an integration unit.
Fig. 10 is a conceptual diagram illustrating an operation principle of the phased-array antenna device.
Fig. 11 is a graph schematically illustrating a result of receiving a microwave of a single frequency using two antenna elements and performing cross-spectrum calculation processing and a result of receiving microwaves of three different frequencies using two antenna elements and performing cross-spectrum calculation processing.

EP 4 075 152 B1

Description of Embodiments

In order to achieve a long-operating-lifespan antenna device, a phased array antenna that does not use a mechanically movable component disclosed in Patent Literature 1 is advantageous. However, in the conventional technique based on analog signals, it is necessary to provide an antenna element and a circuit for each frequency band.

On the other hand, dual-ridged feed horn antennas and quad-ridged feed horn antennas having extremely broad frequency bands in a microwave range have appeared on the market in recent years. Therefore, the phased-array antenna device according to an embodiment of the present invention employs these antenna elements as phased array antennas and digitizes signal processing to achieve a broader band of the phased-array antenna device.

In addition, phased array antennas having the conventional structure cause signal processing circuits to be redundant. Therefore, the phased-array antenna device according to the embodiment of the present invention achieves a non-redundant phased-array antenna device with a minimum configuration of antenna elements and signal processing circuits by applying the technique disclosed in Non-Patent Literature 2.

[Phased-Array Antenna Device: Overall Configuration]

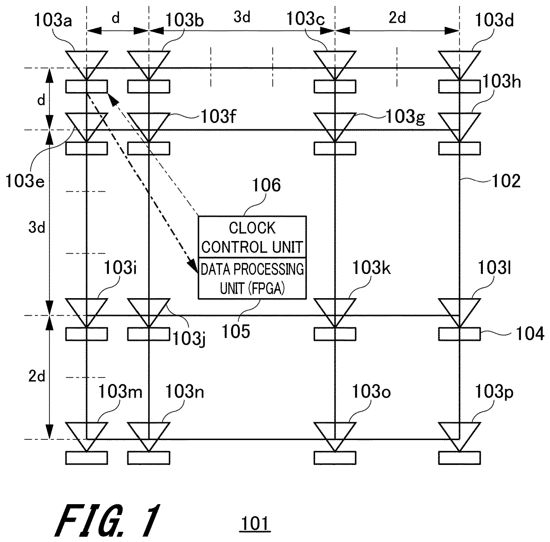

Fig. 1 is a schematic diagram illustrating an overall configuration of a phased-array antenna device 101 according to an embodiment of the present invention.

Antenna elements 103 and front-end units 104 are installed at the intersections of a square-shaped frame 102. The antenna elements 103 are installed at positions corresponding to 0th, first, fourth, and sixth intersections with intervals of a distance d.

At the left end in the first row of the frame 102, a first-row first-column antenna element 103a corresponding to the 0th intersection is installed.

To the right of the first-row first-column antenna element 103a in the first row of the frame 102, a first-row second-column antenna element 103b corresponding to the first intersection is installed, spaced by the distance d.

To the right of the first-row second-column antenna element 103b in the first row of the frame 102, a first-row third-column antenna element 103c corresponding to the fourth intersection is installed, spaced by a distance 3d.

To the right of the first-row third-column antenna element 103c in the first row of the frame 102, a first-row fourth-column antenna element 103d corresponding to the sixth intersection is installed, spaced by a distance 2d.

That is, in the column direction, the 0th antenna element and the first antenna element are spaced by the distance d, the first antenna element and the fourth antenna element are spaced by the distance 3d, and the fourth antenna element and the sixth antenna element are spaced by the distance 2d. The spacing "1-3-2" between these antenna elements 103 is disclosed in Non-Patent Literature 2.

Also in the second row of the frame 102, a second-row first-column antenna element 103e, a second-row second-column antenna element 103f, a second-row third-column antenna element 103g, and a second-row fourth-column antenna element 103h are installed in the same positional relationship as in the first row described above.

Also in the third row of the frame 102, a third-row first-column antenna element 103i, a third-row second-column antenna element 103j, a third-row third-column antenna element 103k, and a third-row fourth-column antenna element 103l are installed in the same positional relationship as in the first row described above.

Also in the fourth row of the frame 102, a fourth-row first-column antenna element 103m, a fourth-row second-column antenna element 103n, a fourth-row third-column antenna element 103o, and a fourth-row fourth-column antenna element 103p are installed in the same positional relationship as in the first row described above.

The first-row first-column antenna element 103a and the second-row first-column antenna element 103e are spaced by the distance d in the longitudinal direction. In other words, below the first-row first-column antenna element 103a in the first column of the frame 102, the second-row first-column antenna element 103e corresponding to the first intersection is installed, spaced by the distance d.

The second-row first-column antenna element 103e and the third-row first-column antenna element 103i are spaced by the distance 3d in the longitudinal direction. In other words, below the second-row first-column antenna element 103e in the first column of the frame 102, the third-row first-column antenna element 103i corresponding to the fourth intersection is installed, spaced by the distance 3d.

The third-row first-column antenna element 103i and the fourth-row first-column antenna element 103m are spaced by the distance 2d in the longitudinal direction. In other words, below the third-row first-column antenna element 103i in the first column of the frame 102, the fourth-row first-column antenna element 103m corresponding to the sixth intersection is installed, spaced by the distance 2d.

That is, similarly in the row direction, the 0th antenna element and the first antenna element are spaced by the distance d, the first antenna element and the fourth antenna element are spaced by the distance 3d, and the fourth antenna element and the sixth antenna element are spaced by the distance 2d.

In addition, this combination of the antenna elements 103 of "0-1-4-6" is a combination with high circuit utilization efficiency for eliminating redundancy in the final addition processing of the phased-array antenna device 101, and this combination is also disclosed in Non-Patent Literature 2.

Note that, as the distance d is longer, the spatial resolution of the antenna can be improved similarly to the diameter of the reflector of a parabola antenna. However, the distance d is limited due to the convenience of equipment to be mounted.

The array antenna can receive a radio wave arriving from a desired narrow angular range with high sensitivity by installing the plurality of antenna elements 103 and superimposing received radio wave signals obtained from the respective antenna elements with a time difference. Conversely, at the time of transmission, the array antenna can transmit a radio wave in a desired narrow angular range with high output by giving a time difference to transmission radio wave signals output to the respective antenna elements. In particular, when a broadband radio wave is received as in the case of the phased-array antenna device 101 according to the embodiment of the present invention, the frequency bands of the antenna elements 103 may be different. At this time, the frequency bands receivable by the entire array antenna are frequency bands receivable by all the antenna elements.

In the known phased array antenna disclosed in Patent Literature 1 and the like, in order to enhance directivity, a plurality of antenna elements 103 is provided on a straight line at equal intervals of a distance d, and the multiplication output of output signals of the antenna elements 103 or the multiplication output after integration is added. Then, this addition makes the directivity of the antenna sharper and reduces the side lobes.

When the seven antenna elements 103 are arranged at equal intervals according to the conventional technique, the following combination is obtained.

[Table 1]

| Distance | Combination |
|---|---|
| d | 0-1, 1-2, 2-3, 3-4, 4-5, 5-6 |
| 2 × d | 0-2, 1-3, 2-4, 3-5, 4-6 |
| 3 × d | 0-3, 1-4, 2-5, 3-6 |
| 4 × d | 0-4, 1-5, 2-6 |
| 5 × d | 0-5, 1-6 |
| 6 × d | 0-6 |

On the other hand, when the antenna elements 103 are arranged at "0-1-4-6", the following combination is obtained.

[Table 2]

| Distance | Combination |
|---|---|
| d | 0-1 |
| 2 × d | 4-6 |
| 3 × d | 1-4 |
| 4 × d | 0-4 |
| 5 × d | 1-6 |
| 6 × d | 0-6 |

Although the above combinations are disclosed in Non-Patent Literature 2, in the phased-array antenna device 101 according to the embodiment of the present invention, the combination of the antenna elements 103 is developed on the longitudinal and lateral plane in order to sharpen the antenna directivity in the two longitudinal and lateral directions and to form a point-like antenna beam. Conventionally, $7 \times 7 = 49$ antenna elements 103 and front ends have to be equipped, but the phased-array antenna device 101 according to the embodiment of the present invention only requires $4 \times 4 = 16$ antenna elements 103 and front ends due to the combination excluding the redundancy.

In addition, the combination of "0-1-4-6" is used in the phased-array antenna device 101 according to the embodiment of the present invention, but if more antenna elements 103 can be installed, it is possible to install the antenna elements 103 using the numerical sequence disclosed in Non-Patent Literature 2 similarly to the above example. For example, when five antenna elements 103 are installed, the spacing is set to "1-3-3-2", and the antenna elements 103 are arranged at "0-1-4-7-9". Then, the following combination is obtained.

[Table 3]

| Distance | Combination |
|----------|-------------|
| d | 0-1 |
| 2 × d | 7-9 |
| 3 × d | 1-4, 4-7 |
| 4 × d | 0-4 |
| 5 × d | 4-9 |
| 6 × d | 1-7 |
| 7 × d | 0-7 |
| 8 × d | 1-9 |
| 9 × d | 0-9 |

[Antenna element 103: External appearance]

Here, the antenna element 103 installed at each intersection of the frame 102 is described.

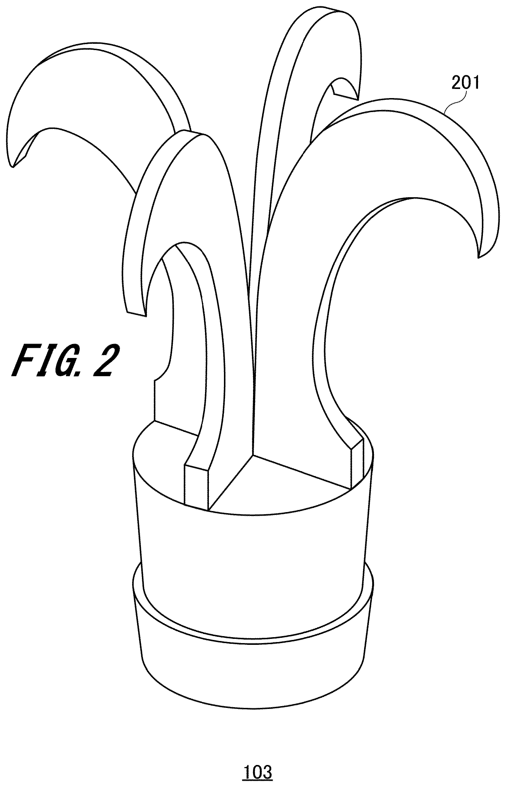

Fig. 2 illustrates an external perspective view of the antenna element 103.

The antenna element 103 is a known quad-ridged feed horn antenna. Examples thereof include QH1400, QH4000, and the like manufactured by MVG Industries in France. In this quad-ridged feed horn antenna, horn antenna elements 201 each having a shape warped in a longitudinal direction and a lateral direction when viewed from the top are formed. The horn antenna elements 201 each having the warped shape achieve an extremely broad frequency band in the microwave range of the antenna element 103.

Returning to Fig. 1, the description of the overall configuration of the phased-array antenna device 101 is continued.

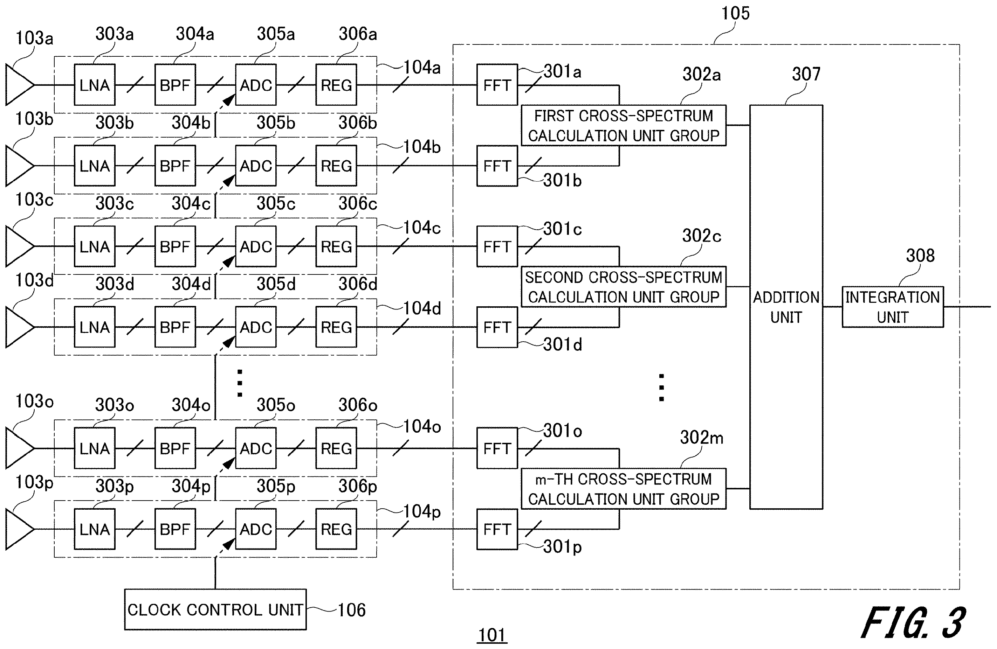

As described above, the front-end unit 104 is installed immediately below each antenna element 103. The front-end unit 104 includes a preamplifier, a distributor, a band-pass filter, an A/D converter, and a register (see Fig. 3). That is, an analog signal obtained from each antenna element 103 is converted into digital data immediately below the antenna element 103.

The digital data obtained from the register is aggregated into a data processing unit 105 installed in the center part of the frame 102. The data processing unit 105 is constituted by a known field-programmable gate array (FPGA). The data processing unit 105 outputs radio-wave intensity data for each desired frequency component.

In addition to the data processing unit 105, a clock control unit 106 is installed in the center part of the frame 102. The clock control unit 106 supplies a sampling clock to the A/D converter inside the front-end unit 104 arranged immediately below each antenna element 103.

Note that, although not illustrated in Fig. 1, the front-end units 104 installed immediately below the respective antenna element 103 are all connected to the data processing unit 105 and the clock control unit 106.

[Phased-Array Antenna Device 101: Overall Configuration Block]

Fig. 3 is a block diagram illustrating the overall configuration of the phased-array antenna device 101.

The first-row first-column antenna element 103a, the first-row first-column front-end unit 104a, and a first-row first-column FFT group 301a, which is a fast Fourier transform unit inside the data processing unit 105, constitute one system of signal processing and data processing.

Similarly, the first-row second-column antenna element 103b, the first-row second-column front-end unit 104b, and a first-row second-column FFT group 301b constitute one system of signal processing and data processing.

Similarly, the first-row third-column antenna element 103c, the first-row third-column front-end unit 104c, and a first-row third-column FFT group 301c constitute one system of signal processing and data processing, and the same applies subsequently.

The first-row fourth-column antenna element 103d, the first-row fourth-column front-end unit 104d, and a first-row fourth-column FFT group 301d constitute one system of signal processing and data processing.

The description for the second row first column to the fourth row second column is omitted.

The fourth-row third-column antenna element 103o, the fourth-row third-column front-end unit 104o, and a fourth-row third-column FFT group 301o constitute one system of signal processing and data processing.

The fourth-row fourth-column antenna element 103p, the fourth-row fourth-column front-end unit 104p, and a fourth-row fourth-column FFT group 301p constitute one system of signal processing and data processing.

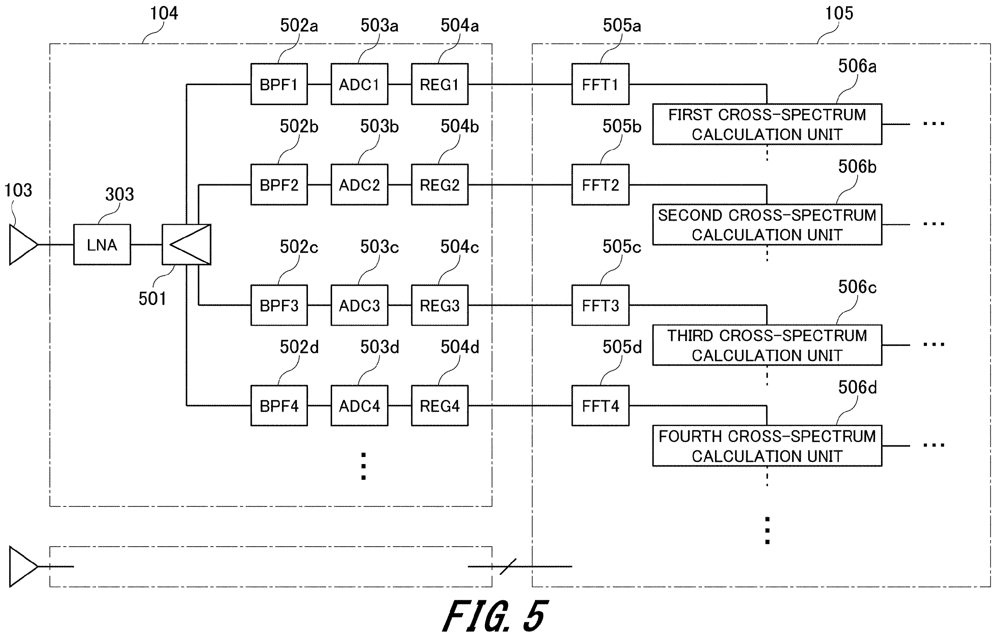

The signal output from the first-row first-column antenna element 103a is amplified by a first-row first-column preamplifier 303a (denoted as "LNA" in Fig. 3, and the same applies to Fig. 5). The output signal of the first-row first-column preamplifier 303a is input to a first-row first-column BPF group 304a ("BPF" in Fig. 3), which is a band-pass filter group. Although Fig. 3 illustrates a single BPF, a plurality of BPFs is provided for each frequency band as described later with reference to Fig. 5. For convenience of explanation, a functional block for signal processing and data processing linked from a single antenna element 103 is referred to as one system in the following description. That is, the front-end unit 104 provided immediately below an antenna element 103 and the FFT group 301, which is provided inside the data processing unit 105, corresponding to the front-end unit 104 belong to one system.

Similarly, the signal output from the first-row second-column antenna element 103b is amplified by a first-row second-column preamplifier 303b. The output signal of the first-row second-column preamplifier 303b is input to a first-row second-column BPF group 304b.

Similarly, the output signal of the first-row third-column antenna element 103c is input to a first-row third-column BPF group 304c through a first-row third-column preamplifier 303c, and the same applies subsequently.

The output signal of the first-row fourth-column antenna element 103d is input to a first-row fourth-column BPF group 304d through a first-row fourth-column preamplifier 303d.

The description for the second row first column to the fourth row second column is omitted.

The output signal of the fourth-row third-column antenna element 103o is input to a fourth-row third-column BPF group 304o through a fourth-row third-column preamplifier 303o.

The output signal of the fourth-row fourth-column antenna element 103p is input to a fourth-row fourth-column BPF group 304p through a fourth-row fourth-column preamplifier 303p.

Hereinafter, the first-row first-column preamplifier 303a to the fourth-row fourth-column preamplifier 303p are collectively referred to as a preamplifier 303, unless distinguished.

The output signal of the first-row first-column BPF group 304a is supplied to a first-row first-column A/D converter group 305a (denoted as "ADC" in Fig. 3, and the same applies to Fig. 5). Although Fig. 3 illustrates a single A/D converter, a plurality of A/D converters is provided for each frequency band as described later with reference to Fig. 5. Then, the clock control unit 106 supplies a sampling clock to a first-row first-column A/D converter group 305a.

The sampling clock is, for example, 16.384 GHz (16384 × $10^6$ Hz). In addition, the sampling clock is an integral multiple of the number of a power of 2. This depends on the convenience of the subsequent FFT group 301. The reason that the sampling clock is an integral multiple of the number of a power of 2 is described later.

Similarly, the output signal of the first-row second-column BPF group 304b is supplied to a first-row second-column A/D converter group 305b.

The output signal of the first-row third-column BPF group 304c is supplied to a first-row third-column A/D converter group 305c.

The output signal of the first-row fourth-column BPF group 304d is supplied to a first-row fourth-column A/D converter group 305d.

The description for the second row first column to the fourth row second column is omitted.

The output signal of the fourth-row third-column BPF group 304o is supplied to a fourth-row third-column A/D converter group 305o.

The output signal of the fourth-row fourth-column BPF group 304p is supplied to a fourth-row fourth-column A/D converter group 305p.

Hereinafter, the first-row first-column A/D converter group 305a to the fourth-row fourth-column A/D converter group 305p are collectively referred to as an A/D converter group 305, unless distinguished.

The sampling clock generated by the clock control unit 106 is supplied to the first-row first-column A/D converter group 305a belonging to the first-row first-column system and to the first-row second-column A/D converter group 305b belonging to the first-row second-column system. At this time, in order to give a relative phase difference to reception signals of the two antenna systems, the clock control unit 106 gives a temporal difference to the sampling-clock supply timing according to a target direction in which the phased-array antenna device 101 receives radio waves.

For example, it is assumed that the sampling clock is relatively shifted by 2 samples between the 0th antenna element 103 and the first antenna element 103 spaced by the distance d. Between the other antenna elements 103, according to the natural number multiple of the distance, the sampling clock is shifted by the same natural number multiple.

First, between the fourth antenna element 103 and the sixth antenna element 103 spaced by the distance 2d, the sampling clock is relatively shifted by 2 × 2 = 4 samples.

Next, between the first antenna element 103 and the fourth antenna element 103 spaced by the distance 3d, the sampling clock is relatively shifted by 2 × 3 = 6 samples.

Then, the sampling clock is relatively shifted by 2 × 4 = 8 samples between the 0th antenna element 103 and the fourth antenna element 103 spaced by the distance 4d.

Then, between the first antenna element 103 and the sixth antenna element 103 spaced by the distance 5d, the sampling clock is relatively shifted by 2 × 5 = 10 samples.

Lastly, between the 0th antenna element 103 and the sixth antenna element 103 spaced by the distance 6d, the sampling clock is relatively shifted by 2 × 6 = 12 samples.

The data output from the first-row first-column A/D converter group 305a is stored in a first-row first-column register group 306a (denoted as "REG" in Fig. 3). Since the A/D converter group 305 is for the ultrahigh-speed sampling clock of 16.384 GHz, DRAMs used in general computers cannot keep up the speed, and thus the output data of the A/D converter is held by high-speed registers. Although Fig. 3 illustrates a single register, a plurality of first-row first-column register groups 306a is provided for each frequency band as described later with reference to Fig. 5.

Similarly, the output signal of the first-row second-column A/D converter group 305b is supplied to a first-row second-column register group 306b.

The output signal of the first-row third-column A/D converter group 305c is supplied to a first-row third-column register group 306c.

The output signal of the first-row fourth-column A/D converter group 305d is supplied to a first-row fourth-column register group 306d.

The description for the second row first column to the fourth row second column is omitted.

The output signal of the fourth-row third-column A/D converter group 305o is supplied to a fourth-row third-column register group 306o.

The output signal of the fourth-row fourth-column A/D converter group 305p is supplied to a fourth-row fourth-column register group 306p.

Hereinafter, the first-row first-column register group 306a to the fourth-row fourth-column register group 306p are collectively referred to as a register group 306, unless distinguished.

The data output from the first-row first-column register group 306a is supplied to a first-row first-column FFT group 301a (denoted as "FFT" in Fig. 3).

The first-row first-column FFT group 301a is a collection of a plurality of FFTs, and a single FFT handles, for example, known input data having 1024 points. Then, a known fast Fourier transform is performed on the 1024 pieces of sample data held in the first-row first-column register group 306a to convert the sample data into 512 pairs of complex frequency data. This processing is repeated for every 1024 samples of the input finite length digital data.

Similarly, the output data of the first-row second-column register group 306b is supplied to a first-row second-column FFT group 301b.

The output data of the first-row third-column register group 306c is supplied to a first-row third-column FFT group 301c.

The output data of the first-row fourth-column register group 306d is supplied to a first-row fourth-column FFT group 301d.

The description for the second row first column to the fourth row second column is omitted.

The output data of the fourth-row third-column register group 306o is supplied to a fourth-row third-column FFT group 301o.

The output data of the fourth-row fourth-column register group 306p is supplied to a fourth-row fourth-column FFT group 301p.

Hereinafter, the first-row first-column FFT group 301a to the fourth-row fourth-column FFT group 301p are collectively referred to as an FFT group 301, unless distinguished.

The output data of the first-row first-column FFT group 301a and the output data of the first-row second-column FFT group 301b are input to a first cross-spectrum calculation unit group 302a. The first cross-spectrum calculation unit group 302a performs multiplication processing for each of the same complex frequency components after converting one of the output data of the first-row first-column FFT group 301a and the output data of the first-row second-column FFT group 301b into a conjugate complex number.

Similarly, the output data of the first-row third-column FFT group 301c and the output data of the first-row fourth-column FFT group 301d are input to a second cross-spectrum calculation unit group 302b.

The description for the second row first column to the fourth row second column is omitted.

Similarly, the output data of the fourth-row third-column FFT group 301o and the output data of the fourth-row fourth-column FFT group 301p are input to an m-th cross-spectrum calculation unit group 302m.

Hereinafter, the first cross-spectrum calculation unit group 302a to the m-th cross-spectrum calculation unit group 302m are collectively referred to as a cross-spectrum calculation unit group 302, unless distinguished.

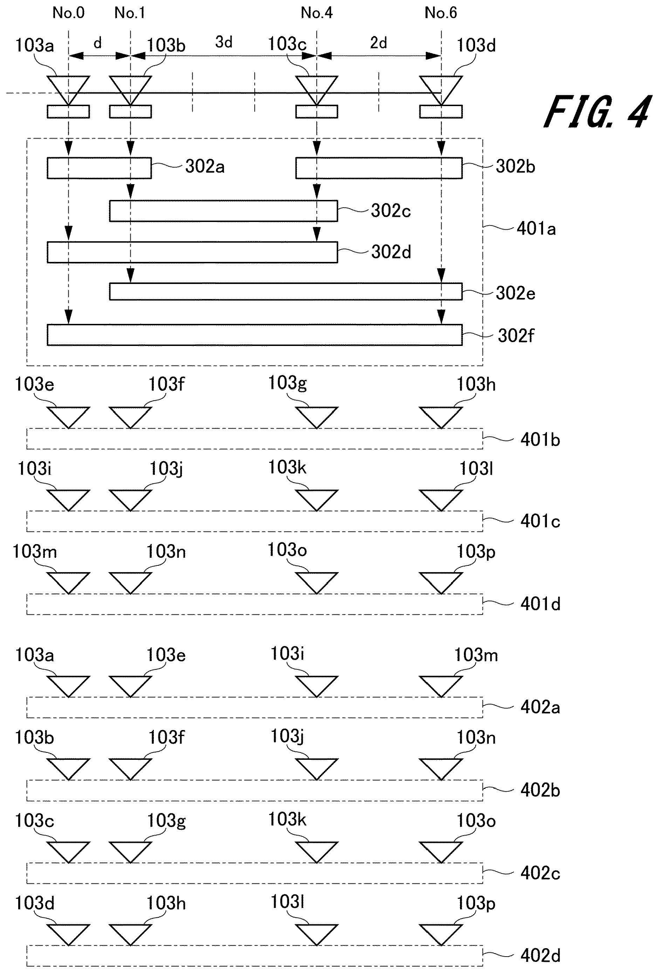

Fig. 4 is a schematic diagram illustrating the number of mounted cross-spectrum calculation unit groups 302. In order to simplify the illustration and explanation, the front-end unit 104 and the FFT group 301 are not illustrated in Fig. 4.

The data obtained from the first-row first-column antenna element 103a and the data obtained from the first-row second-column antenna element 103b are supplied to the first cross-spectrum calculation unit group 302a.

The data obtained from the first-row third-column antenna element 103c and the data obtained from the first-row fourth-column antenna element 103d are supplied to the second cross-spectrum calculation unit group 302b.

The data obtained from the first-row second-column antenna element 103b and the data obtained from the first-row third-column antenna element 103c are supplied to the third cross-spectrum calculation unit group 302c.

The data obtained from the first-row first-column antenna element 103a and the data obtained from the first-row third-column antenna element 103c are supplied to the fourth cross-spectrum calculation unit group 302d.

The data obtained from the first-row second-column antenna element 103b and the data obtained from the first-row fourth-column antenna element 103d are supplied to a fifth cross-spectrum calculation unit group 302e.

The data obtained from the first-row first-column antenna element 103a and the data obtained from the first-row fourth-column antenna element 103d are supplied to a sixth cross-spectrum calculation unit group 302f.

For each group of antennas in a row, six cross-spectrum calculation unit groups 302 are defined as a cross-spectrum calculation group 401.

The first-row first-column antenna element 103a, the first-row second-column antenna element 103b, the first-row third-column antenna element 103c, and the first-row fourth-column antenna element 103d are a group of antenna elements belonging to one row.

The six cross-spectrum calculation unit groups 302 of the first cross-spectrum calculation unit group 302a, the second cross-spectrum calculation unit group 302b, the third cross-spectrum calculation unit group 302c, the fourth cross-spectrum calculation unit group 302d, the fifth cross-spectrum calculation unit group 302e, and the sixth cross-spectrum calculation unit group 302f that process the data obtained from the group of the antennas in one row are defined as a first cross-spectrum calculation group 401a.

Similarly, the six cross-spectrum calculation unit groups 302 (not illustrated) that process signals of the second-row first-column antenna element 103e to the second-row fourth-column antenna element 103h are defined as a second cross-spectrum calculation group 401b.

The six cross-spectrum calculation unit groups 302 (not illustrated) that process signals of the third-row first-column antenna element 103i to the third-row fourth-column antenna element 103l are defined as a third cross-spectrum calculation group 401c.

The six cross-spectrum calculation unit groups 302 (not illustrated) that process signals of the fourth-row first-column antenna element 103m to the fourth-row fourth-column antenna element 103p are defined as a fourth cross-spectrum calculation group 401d.

Next, for each group of antennas in a column, six cross-spectrum calculation unit groups 302 are defined as a cross-spectrum calculation group 402. The details of the cross-spectrum calculation group 402 are the same as those of the cross-spectrum calculation group 401.

The six cross-spectrum calculation unit groups 302 (not illustrated) that process signals of the first-row first-column antenna element 103a, the second-row first-column antenna element 103e, the third-row first-column antenna element 103i, and the fourth-row first-column antenna element 103m are defined as a fifth cross-spectrum calculation group 402a.

The six cross-spectrum calculation unit groups 302 (not illustrated) that process signals of the first-row second-column antenna element 103b, the second-row second-column antenna element 103f, the third-row second-column antenna element 103j, and the fourth-row second-column antenna element 103n are defined as a sixth cross-spectrum calculation group 402b.

The six cross-spectrum calculation unit groups 302 (not illustrated) that process signals of the first-row third-column antenna element 103c, the second-row third-column antenna element 103g, the third-row third-column antenna element 103k, and the fourth-row third-column antenna element 103o are defined as a sixth cross-spectrum calculation group 402c.

The six cross-spectrum calculation unit groups 302 (not illustrated) that process signals of the first-row fourth-column antenna element 103d, the second-row fourth-column antenna element 103h, the third-row fourth-column antenna element 103l, and the fourth-row fourth-column antenna element 103p are defined as a sixth cross-spectrum calculation group 402d.

As clarified from the above description, one cross-spectrum calculation unit group 302 is provided for each two data processing systems. As described with reference to Fig. 4, there are six cross-spectrum calculation unit groups 302 for each set of antenna elements 103 in a column. Since there are four sets of these groups in each of the longitudinal and lateral directions, there are $6 \times 4 \times 2 = 48$ cross-spectrum calculation unit groups 302 inside the data processing unit 105.

The cross-spectrum component data for each complex frequency output from each cross-spectrum calculation unit group 302 is input to the addition unit 307. The addition unit 307 performs addition processing of the cross-spectrum component data for each predetermined frequency range. Similarly to the output data of the FFT group 301, the cross-spectrum component data is complex number data and includes a real part and an imaginary part. The addition unit 307 performs addition processing on the complex number data for each of the same time and the same complex frequency component.

By this addition processing, output data of a large number of cross-spectrum calculation unit groups 302 is aggregated into complex number data for one system.

The output data of the addition unit 307 is input to an integration unit 308.

The integration unit 308 performs integration processing on $16 \times 10^6$ pieces of complex frequency data existing on the time axis of 1 second for each complex frequency component. Eventually, the complex frequency component data of the FFT group 301 for a 1-second measurement is output from the integration unit 308.

A conventional phased array antenna, which is constituted only by analog signal processing, uses delay lines for delay processing. This is literally a plurality of conducting wires of different lengths, and delay lines of different lengths are selected by a switch according to a time to be delayed. Such delay lines are difficult to create large delays.

In contrast, the phased-array antenna device 101 according to the embodiment of the present invention uses a relative timing difference of sample clocks for delay. Therefore, it is possible to set a large delay time.

[Phased-Array Antenna Device 101: Functional Blocks of One System]

In the following, more detailed data processing of the phased-array antenna device 101 and how a signal input from the antenna element 103 is converted into data output from the last integration unit 308 are described with reference to the drawings.

Fig. 5 is a block diagram illustrating a functional configuration of one system of the phased-array antenna device 101.

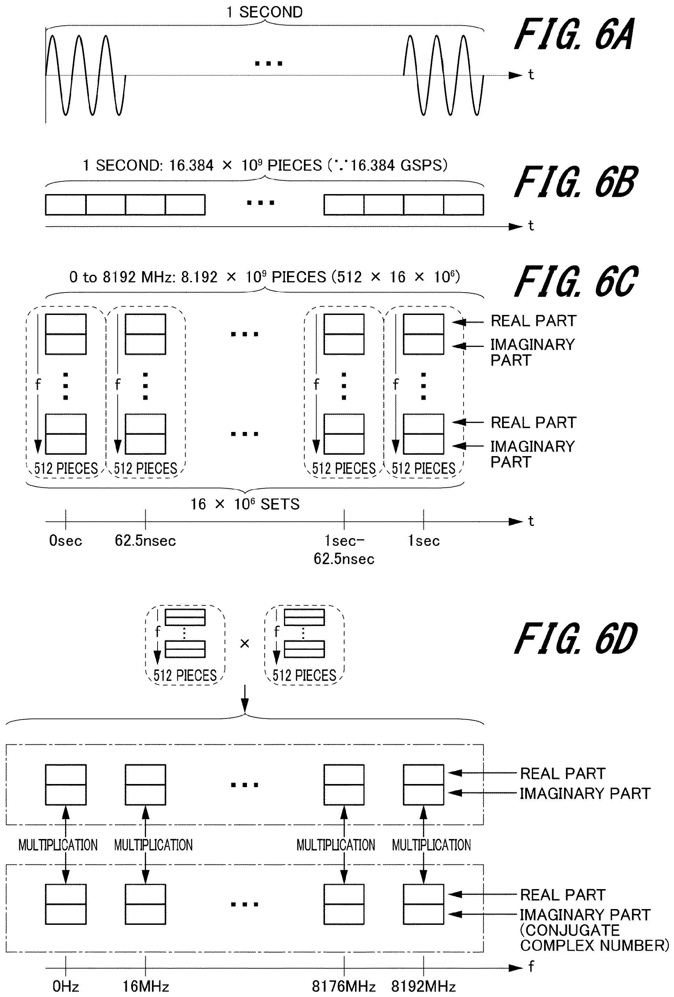

Fig. 6A is a schematic diagram conceptually illustrating an analog signal output from the preamplifier 303.

Fig. 6B is a schematic diagram conceptually illustrating digital data obtained from an A/D converter 503.

Fig. 6C is a schematic diagram conceptually illustrating complex frequency data obtained from an FFT 505.

Fig. 6D is a schematic diagram conceptually illustrating the calculation of a cross-spectrum calculation unit 506.

As illustrated in Fig. 5, the signal output from the antenna element 103 is amplified by the preamplifier 303. The output signal of the preamplifier 303 as illustrated in Fig. 6A is branched into a plurality of signals by a distributor 501. Hereinafter, one row of circuit functional blocks that process the plurality of output signals output from the distributor 501 is referred to as a subsystem. That is, the front-end unit 104 and the FFT in one system connected to one antenna element 103 is constituted by circuit functional blocks of a plurality of subsystem.

A first BPF 502a (abbreviated as "BPF1" in Fig. 5), which is a first band-pass filter belonging to a first subsystem, passes a radio wave in a first band of 0 to 8192 MHz.

A second BPF 502b (abbreviated as "BPF2" in Fig. 5), which is a second band-pass filter belonging to a second subsystem, passes a radio wave in a second band of 8192 to 16384 MHz.

A third BPF 502c (abbreviated as "BPF3" in Fig. 5), which is a third band-pass filter belonging to a third subsystem, passes a radio wave in a third band of 16384 to 24576 MHz.

A fourth BPF 502d (abbreviated as "BPF4" in Fig. 5), which is a fourth band-pass filter belonging to a fourth subsystem, passes a radio wave in a fourth band of 24576 to 32768 MHz.

Although only the first subsystem to the fourth subsystem are illustrated in Fig. 5, it is needless to say that more subsystems can be provided. In that case, BPFs for (k - 1) $\times$ 8192 to k $\times$ 8192 MHz (k is a natural number) are provided.

As the first BPF 502a, the second BPF 502b, the third BPF 502c, and the fourth BPF 502d included in the respective subsystems, BPFs having an extremely steep shoulder characteristic are adopted in order to strictly act an aliasing effect to be described later.

In the phased-array antenna device 101 according to the embodiment of the present invention, the sampling frequency is intentionally set to $16384 \times 10^6$ Hz (16.384 GHz) in order to set the interval of the frequency component that is the final output of the FFT to a manageable value (16 MHz) that is a natural number multiple of a hexadecimal number. That is, as a result of performing the fast Fourier transform processing by the 1024-point FFT, the interval of the frequency component that is the final output is (16384/2)/512 = 16 MHz.

In contrast, if the sampling frequency is set to 16 GHz, which is a multiple of 16 MHz used frequently in conventional electronic circuits, the interval of the frequency component that is final output is (16000/2)/512 = 15.625 MHz as a result of performing the fast Fourier transform processing by the 1024-point FFT.

For example, when the order of 4000 MHz data is searched for from data of each frequency component arranged at intervals of 16 MHz or 15.625 MHz, the former is the easiest method to intuitively derive the result.

That is, from the viewpoint of product usability, an optimal sampling frequency is determined in order to set the interval of the final output to a manageable value.

Then, by setting the sampling frequency to an integral multiple of a power of 2, the number of data samples can be handled as a power of 2. In addition, data is easily analyzed because the intensity of the finally obtained frequency component is separated by every 16 MHz.

This sampling frequency setting and the frequency band setting described later enable seamless acquisition of the intensity of radio waves with frequency components in a broad frequency band, which cannot be achieved by the signal processing of the conventional analog circuit.

The output signal of the first BPF 502a of the first subsystem is input to a first A/D converter 503a ("ADC1" in Fig. 5).

The output signal of the second BPF 502b of the second subsystem is input to a second A/D converter 503b ("ADC2" in Fig. 5).

The output signal of the third BPF 502c of the third subsystem is input to a third A/D converter 503c ("ADC3" in Fig. 5).

The output signal of the fourth BPF 502d of the fourth subsystem is input to a fourth A/D converter 503d ("ADC4" in Fig. 5).

The functional blocks connected to the output side of each of the first BPF 502a, the second BPF 502b, the third BPF 502c, and the fourth BPF 502d are the same circuit functional blocks in each subsystems.

Each of the first A/D converter 503a, the second A/D converter 503b, the third A/D converter 503c, and the fourth A/D converter 503d performs A/D conversion on an analog signal input from each BPF and outputs digital data as illustrated in Fig. 6B.

The first A/D converter 503a, the second A/D converter 503b, the third A/D converter 503c, and the fourth A/D converter 503d are A/D converters having the same circuit configuration. Then, all of them perform A/D conversion with a sampling clock of 16.384 GHz.

Hereinafter, the first A/D converter 503a, the second A/D converter 503b, the third A/D converter 503c, and the fourth A/D converter 503d are collectively referred to as an A/D converter 503, unless distinguished.

Therefore, by the Nyquist's theorem, the A/D converter 503 can perform A/D conversion on signals with frequencies up to 8.192 GHz. Regarding signals with frequencies above 8.192 GHz, signals that appear as a low frequency by applying aliasing are subjected to A/D conversion.

For example, a signal of 8.2 GHz passes through only the second BPF 502b of the second subsystem. Then, the signal is detected by the second A/D converter 503b as aliasing noise of 8200 - 8192 = 8 MHz. However, if the second A/D converter 503b performs A/D conversion on the signal of 8 MHz, this is substantially equivalent to the A/D conversion of a signal of 8.2 GHz in practical.

As described above, the functional blocks connected to the output side of each of the first BPF 502a, the second BPF 502b, the third BPF 502c, and the fourth BPF 502d are the same circuit functional blocks in each subsystems. That is, the first A/D converter 503a, the second A/D converter 503b, the third A/D converter 503c, and the fourth A/D converter 503d are A/D converters having the same circuit configuration.

A first register 504a ("REG1" in Fig. 5), a second register 504b ("REG2" in Fig. 5), a third register 504c ("REG3" in Fig. 5), and a fourth register 504d ("REG4" in Fig. 5) are registers having the same circuit configuration.

A first FFT 505a ("FFT1" in Fig. 5), a second FFT 505b ("FFT2" in Fig. 5), a third FFT 505c ("FFT3" in Fig. 5), and a fourth FFT 505d ("FFT4" in Fig. 5) are FFTs having the same circuit configuration.

In addition, a first cross-spectrum calculation unit 506a, a second cross-spectrum calculation unit 506b, a third cross-spectrum calculation unit 506c, and a fourth cross-spectrum calculation unit 506d connected to the respective subsystems have the same circuit configuration.

Therefore, in order to eliminate redundancy in the explanation, only the first subsystem that receives radio waves in the first band of 0 to 8196 MHz is described below.

Hereinafter, the first FFT 505a, the second FFT 505b, the third FFT 505c, and the fourth FFT 505d are referred to as an FFT 505, unless distinguished.

Similarly, the first cross-spectrum calculation unit 506a, the second cross-spectrum calculation unit 506b, the third cross-spectrum calculation unit 506c, and the fourth cross-spectrum calculation unit 506d are referred to as a cross-spectrum calculation unit 506, unless distinguished.

The output data of the first A/D converter 503a is held by the first register 504a. Then, the digital data held in the first register 504a is supplied to the first FFT 505a.

The first FFT 505a performs a known fast Fourier transform on the sample data for one second held in the first register 504a for every 1024 pieces of sample data to convert the sample data into 512 pairs of complex frequency data. This processing is repeated for the sample data for one second.

The first register 504a stores $16384 \times 10^6$ pieces of sample data. In contrast, the first FFT 505a performs FFT for every 1024 pieces of sample data. That is, the first FFT 505a performs FFT $16384 \times 10^6 = 1024 = 16 \times 10^6$ times. Then, the digital data illustrated in Fig. 6B is converted into $16 \times 10^6$ sets of 512 pieces of complex frequency data as illustrated in Fig. 6C.

In Fig. 6C, the 512 pieces of complex frequency data correspond to the sample data held in the first register 504a for 1 sec $\div (16 \times 10^6) = 62.5 \times 10^{-9}$ sec = 62.5 nsec. Therefore, the scale interval on the horizontal axis in Fig. 6C is 62.5 nsec.

The data illustrated in Fig. 6C is the result of the FFT processing on the signals of the radio waves in the first band of 0 to 8192 MHz in the first subsystem. This amount of data continues in the second subsystem, the third subsystem, and the fourth subsystem, and the like for each different frequency band.

The complex frequency data output from the first FFT 505a is input to the first cross-spectrum calculation unit 506a. For the complex frequency component data output from the FFTs of the two subsystems, the cross-spectrum calculation unit multiplies the data that is at the same time and of the same complex frequency component after reversing the signs of the complex components of the complex frequency component data output from one of the FFTs. Reversing the signs of the complex components of the complex frequency component data output from one of the FFTs means obtaining a conjugate complex number of the complex frequency component data output from one of the FFTs. This calculation is the definition equation for the cross spectrum shown below.

[Expression 1]

$$X = G_1 G_2 V_0(f) V_0^*(f) e^{-j2\pi f\tau}$$
$$\Delta = c\tau = d\sin\theta \ , \theta = \sin^{-1}(c\tau/d)$$

where,

X: cross spectrum,
$G_1$: gain of first antenna,
$G_2$: gain of second antenna,
$V_0(f)$: frequency component of output signal of first antenna,
$V_0^*(f)$: conjugate complex number of frequency component of output signal of first antenna,
$\tau$: phase difference,
$\Delta$: optical path difference,
c: light velocity,
d: distance between antennas, and
$\theta$: azimuth.

Note that, in the above definition equation for the cross spectrum, the term exp(-j2πfτ) indicating the azimuth is achieved by shifting the input timing of the sampling clock by the clock control unit 106 in the A/D converter 503.

Fig. 6D is a schematic diagram conceptually illustrating calculation of complex frequency data at a certain time in the first cross-spectrum calculation unit 506a. There are 512 pieces of complex frequency data output from an FFT of one system every 16 MHz from 0 Hz. These pieces of complex frequency data are multiplied by the pieces of complex frequency data of the corresponding frequency component of the other system after converting ones of them into conjugate complex numbers.

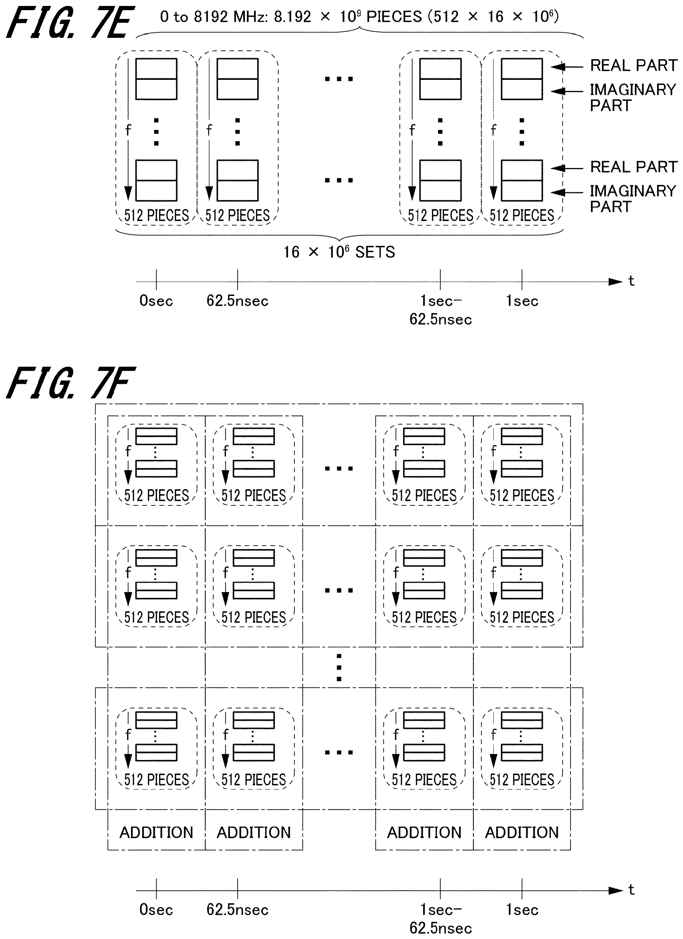

Fig. 7E is a schematic diagram conceptually illustrating a complex frequency component data group output from the first cross-spectrum calculation unit 506a. The multiplication of the complex frequency data output from the FFTs of two systems is performed, and the number and form of the data are the same as the output of the FFTs illustrated in Fig. 6C.

Fig. 7F is a schematic diagram conceptually illustrating an overall image of the calculation of the addition unit 307.

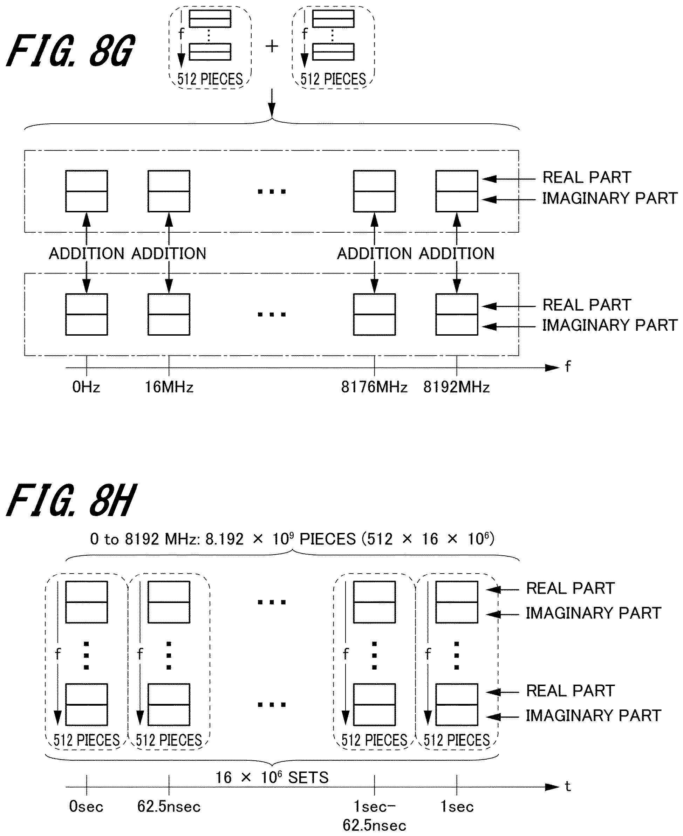

Fig. 8G is a schematic diagram conceptually illustrating a part of the calculation of the addition unit 307.

As illustrated in Fig. 7F, the addition unit 307 performs addition processing on the output data of a large number of cross-spectrum calculation units 506 in the $6 \times 6 = 36$ sets of cross-spectrum calculation unit group 302 included inside the data processing unit 105, for the same time axis and the same frequency component. More specifically, as illustrated in Fig. 8G, the same frequency components are added together for the output data of two sets of FFTs on the same time axis.

Fig. 8H is a schematic diagram conceptually illustrating a form of the data output by the addition unit 307.

The output data of a large number of cross-spectrum calculation units 506 is combined into one set by the addition unit 307, and the form is the same as the form of the complex frequency data illustrated in Figs. 6C and 7E.

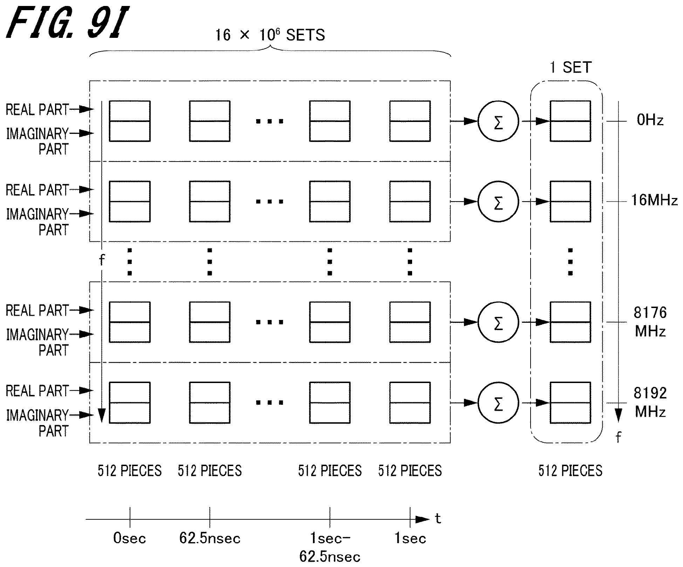

Fig. 9I is a schematic diagram conceptually illustrating the calculation of the integration unit 308.

The integration unit 308 performs integration processing on 512 sets of complex frequency data output from the addition unit 307, which are $16 \times 10^6$ pieces in the time axis direction, for each same frequency component. That is, the integration of the integration unit 308 is equivalent to time integration of the output data of the addition unit 307. Eventually, 512 sets of complex frequency data are obtained from the integration unit 308.

To the FFT 505, 1024 pieces of data are input. If the FFT 505 is operated only once, data output from the A/D converter for 62.5 nsec is used. However, RFI is generated by various devices on the ground, and RFI caused by artificial radio waves is an extremely strong radio wave, compared with weak electromagnetic waves generated by natural objects.

For this reason, in order to remove the influence of RFI as much as possible, it is preferable to sufficiently reduce the influence of RFI by time-integration for a long time. Thus, a measurement for a long time of one second is performed, the FFT 505 is repeatedly operated for the obtained enormous digital data, and the cross spectrum of each set of antennas is calculated. After all of the cross spectra are added, the integration unit 308 performs the time integration.

In Figs. 6 to 9, only signal processing and data processing in a frequency range in the first band of 0 to 8.192 GHz have been described. This processing is performed simultaneously in the second band of 8.192 to 16.384 GHz, the third band 16.384 to 24.576 GHz, and the fourth band 24.576 to 32.768 GHz, and the like.

[Phased-Array Antenna Device 101: Operation Principle]

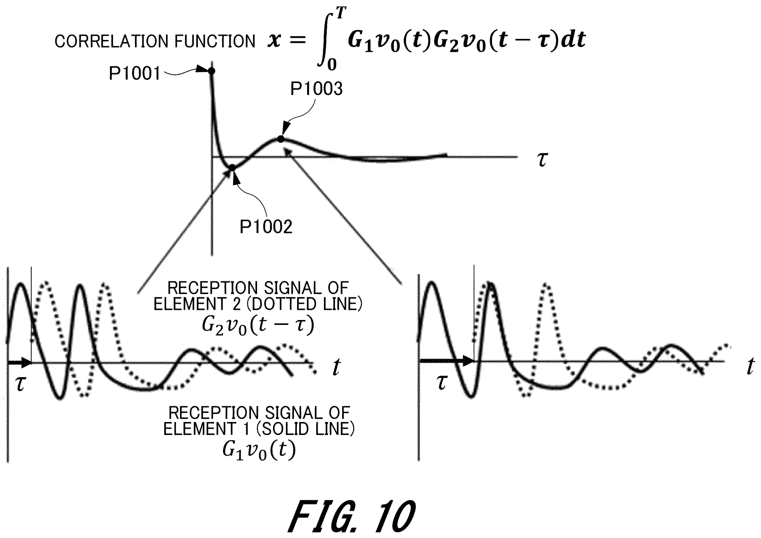

Fig. 10 is a conceptual diagram illustrating an operation principle of the phased-array antenna device 101.
When the output signals of the two antenna elements 103 are multiplied and integrated at a certain time T, cross correlation of the output signals of the two antennas at the integration time T can be obtained. The definition equation of the cross correlation is expressed by the following expression.

[Expression 2]

$$x = \int_0^T v(t)v(t-\tau)dt = \int_0^T G_1 v_0(t)G_2 v_0(t-\tau)dt$$

where,

x: cross correlation,
T: integrated time,
v(t): output signal of first antenna,
v(t - $\tau$): output signal of second antenna,
$\tau$: phase difference,
$v_0(t)$: frequency component of output signal of first antenna,
$G_1$: gain of first antenna, and
$G_2$: gain of second antenna.

In the above definition equation of the cross correlation, $\tau$ is a delay given to the antenna element 103. Fig. 10 illustrates that the cross correlation x is at the maximum value when $\tau$ is 0 (point P1001), x decreases as soon as $\tau$ starts to have a value (point P1002), x slightly increases as $\tau$ further increases (point P1003), and thereafter, x converges to a value around 0 as $\tau$ increases. Therefore, if $\tau$ is electrically changed, it is possible to change the reception sensitivity azimuth of the cross correlation obtained from the two antenna elements 103.

[Phased-Array Antenna Device 101: Experimental Result]

In order to verify the validity of the present invention, the inventors performed almost the same signal processing and data processing as shown in Figs. 3 and 5, using two antenna elements 103 to receive microwaves of a plurality of frequencies.

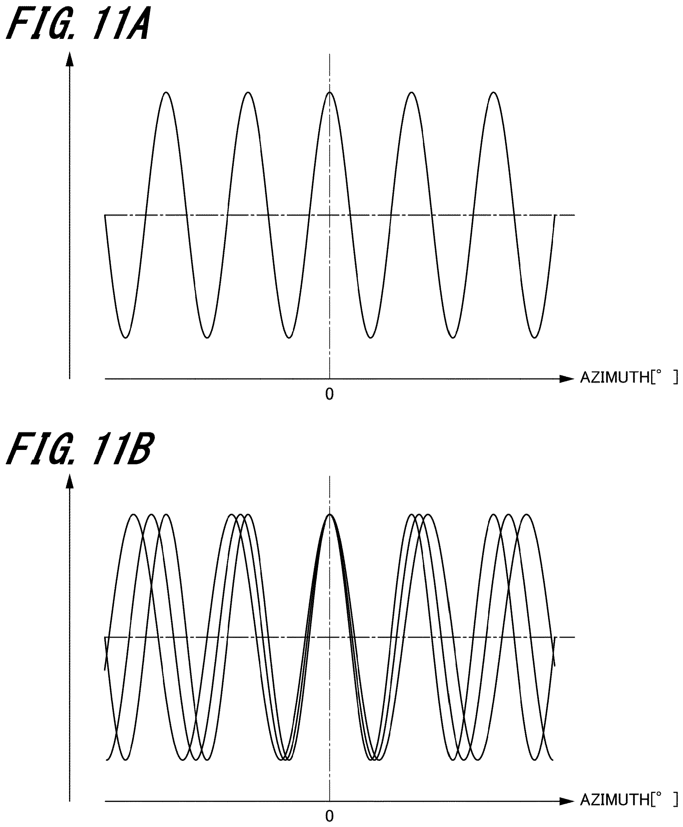

Fig. 11A is a graph schematically illustrating a result of receiving a microwave of a single frequency using two antenna elements 103 and performing cross-spectrum calculation processing. The horizontal axis represents the azimuth, and the vertical axis represents the normalized cross spectrum intensity.
Fig. 11B is a graph schematically illustrating a result of receiving a microwave of three different frequencies using two antenna elements 103 and performing cross-spectrum calculation processing. The horizontal axis represents the azimuth, and the vertical axis represents the normalized cross spectrum intensity. Therefore, there is no unit on the vertical axis.
Note that, in the schematic graphs illustrated in Figs. 11A and 11B, no relative delay was given to the output data of the two antenna elements 103.
The schematic graph in Fig. 11A illustrates that the cross spectrum is the maximum value at an azimuth of 0° and that the cross spectrum periodically increases or decreases as the azimuth deviates. The area where the gain increases or decreases deviating from the center of the original azimuth is a grating lobe. Then, Fig. 11B shows that the cross spectrum is the maximum value at the azimuth of 0° even in the case of a plurality of frequencies, and that the grating lobe increases or decreases depending on the frequencies.

The phased-array antenna device 101 described above has a shape in which the antenna array is developed in the longitudinal and lateral directions as illustrated in Fig. 1 in order to form a point-like antenna beam having sharp directivity in a three-dimensional space, but may be a straight antenna array if the directivity of the antenna in a two-dimensional space is considered.

The phased-array antenna device 101 described above has the following configuration.

Referring to Fig. 1, the first-row first-column antenna element 103a is used as a reference and is described as a first antenna element. Then, the first-row first-column preamplifier 303a that amplifies the signal output from the first-row first-column antenna element 103a can be described as a first preamplifier that amplifies the signal obtained from the first antenna element.

Next, the first-row first-column BPF group 304a that passes only a signal in a predetermined frequency band from the output signal of the first-row first-column preamplifier 303a can be described as a first BPF that passes only a signal in a predetermined frequency band from the output signal of the first preamplifier.

Next, the first-row first-column A/D converter group 305a that converts the output signal of the first-row first-column BPF group 304a into digital data can be described as a first A/D converter that converts the output signal of the first BPF into digital data.

Next, the first-row first-column FFT group 301a that performs a Fourier transform on the data output from the first-row first-column A/D converter group 305a can be described as a first FFT that performs a Fourier transform on the data output from the first A/D converter.

Next, the first-row second-column antenna element 103b arranged next to the first-row first-column antenna element 103a, spaced apart by the distance d can be described as a second antenna element arranged apart from the first antenna element by a predetermined distance.

Next, the first-row second-column preamplifier 303b that amplifies the signal output from the first-row second-column antenna element 103b can be described as a second preamplifier that amplifies the signal obtained from the second antenna element.

Next, the first-row second-column BPF group 304b that passes only a signal in a predetermined frequency band from the output signal of the first-row second-column preamplifier 303b can be described as a second BPF that passes only a signal in a predetermined frequency band from the output signal of the second preamplifier.

Next, the first-row second-column A/D converter group 305b that converts the output signal of the first-row second-column BPF group 304b into digital data can be described as a second A/D converter that converts the output signal of the second BPF into digital data.

Next, the first-row second-column FFT group 301b that performs a Fourier transform on the data output from the first-row second-column A/D converter group 305b can be described as a second FFT that performs a Fourier transform on the data output from the second A/D converter.

Next, the first cross-spectrum calculation unit group 302a that multiplies the output data of the first-row first-column FFT group 301a and the output data of the first-row second-column FFT group 301b for the same complex frequency component after converting one of them into a conjugate complex number can be described as a first cross-spectrum calculation unit that multiplies the output data of the first FFT and the output data of the second FFT for the same complex frequency component after converting one of them into a conjugate complex number.

Then, the clock control unit 106 that supplies a sampling clock whose output timing is relatively shifted to the first-row first-column A/D converter group 305a and the first-row second-column A/D converter group 305b can be described as a clock control unit that supplies a sampling clock whose output timing is relatively shifted to the first A/D converter and the second A/D converter.

Furthermore, the first-row third-column antenna element 103c is arranged on a straight line on which the first-row first-column antenna element 103a and the first-row second-column antenna element 103b are arranged, spaced apart from the first-row second-column antenna element 103b by a distance that is a natural number multiple of the distance between the first-row first-column antenna element 103a and the first-row second-column antenna element 103b. The first-row third-column antenna element 103c can be described as a third antenna element that is arranged on a straight line on which the first antenna element and the second antenna element are arranged, spaced apart from the second antenna element by a distance that is a natural number multiple of the distance between the first antenna element and the second antenna element.

Next, the first-row third-column preamplifier 303c that amplifies the signal obtained from the first-row third-column antenna element 103c can be described as a third preamplifier that amplifies the signal obtained from the third antenna element.

Next, the first-row third-column BPF group 304c that passes only a signal in the same frequency band as the first-row first-column BPF group 304a from the output signal of the first-row third-column preamplifier 303c can be described as a third BPF that passes only a signal in in the same frequency band as the first BPF from the output signal of the third preamplifier.

Next, the first-row third-column A/D converter group 305c that converts the output signal of the first-row third-column BPF group 304c into digital data can be described as a third A/D converter that converts the output signal of the third BPF into digital data.

Next, the first-row third-column FFT group 301c that performs a Fourier transform on the data output from the first-row third-column A/D converter group 305c can be described as a third FFT that performs a Fourier transform on the data output from the third A/D converter.

Next, the fourth cross-spectrum calculation unit group 302d that multiplies the output data of the first-row first-column FFT group 301a and the output data of the first-row third-column FFT group 301c for the same complex frequency component after converting one of them into a conjugate complex number can be described as a second cross-spectrum calculation unit that multiplies the output data of the first FFT and the output data of the third FFT for the same complex frequency component after converting one of them into a conjugate complex number.

Next, the third cross-spectrum calculation unit group 302c that multiplies the output data of the first-row second-column FFT group 301b and the output data of the first-row third-column FFT group 301c for the same complex frequency component after converting one of them into a conjugate complex number can be described as a third cross-spectrum calculation unit that multiplies the output data of the second FFT and the output data of the third FFT for the same complex frequency component after converting one of them into a conjugate complex number.

Furthermore, the second-row first-column antenna element 103e is arranged on a straight line orthogonal to the straight line on which the first-row first-column antenna element 103a and the first-row second-column antenna element 103b are arranged and on a straight line intersecting the first-row first-column antenna element 103a, spaced apart from the first-row first-column antenna element 103a by a distance that is a natural number multiple of the distance between the first-row first-column antenna element 103a and the first-row second-column antenna element 103b. The second-row first-column antenna element 103e can be described as a fourth antenna element that is arranged on a straight line orthogonal to the straight line on which the first antenna element and the second antenna element are arranged and on a straight line intersecting the first antenna element, spaced apart from the first antenna element by a distance that is a natural number multiple of the distance between the first antenna element and the second antenna element.

For the second-row first-column antenna element 103e, there is a preamplifier, which is not illustrated in Fig. 4, that amplifies the signal obtained from the second-row first-column antenna element 103e, similarly to the first-row first-column antenna element 103a, the first-row second-column antenna element 103b, the first-row third-column antenna element 103c, and the first-row fourth-column antenna element 103d. This preamplifier can be described as a fourth preamplifier that amplifies the signal obtained from the fourth antenna element.

Similarly, for the preamplifier that amplifies the signal obtained from the second-row first-column antenna element 103e, there is a BPF group, which is not illustrated in Fig. 4, that passes only a signal in the same frequency band as the first-row first-column BPF group 304a from the output signal of the preamplifier. This BPF group can be described as a fourth BPF that passes only a signal in the same frequency band as the first BPF from the output signal of the fourth preamplifier.

Similarly, for the BPF group that passes only a signal in a predetermined frequency band from the signal obtained from the second-row first-column antenna element 103e, there is an A/D converter group, which is not illustrated in Fig. 4, that converts the output signal of the BPF group into digital data. This A/D converter group can be described as a fourth A/D converter that converts the output signal of the fourth BPF into digital data.

Similarly, for the A/D converter group that converts the signal obtained from the second-row first-column antenna element 103e into digital data, there is an FFT, which is not illustrated in Fig. 4, that performs a Fourier transform on the output data of the A/D converter group. This FFT can be described as a fourth FFT that performs Fourier transform on the data output from the fourth A/D converter.

Then, the fifth cross-spectrum calculation groups 402a, which is not illustrated in Fig. 4, includes six cross-spectrum calculation unit groups 302 (not illustrated) that process signals of the first-row first-column antenna element 103a, the second-row first-column antenna element 103e, the third-row first-column antenna element 103i, and the fourth-row first-column antenna element 103m. Therefore, for the fifth cross-spectrum calculation group 402a, there is a cross-spectrum calculation unit group, which corresponds to the first cross-spectrum calculation unit group 302a in Fig. 4, that processes signals of the first-row first-column antenna element 103a and the second-row first-column antenna element 103e. The cross-spectrum calculation unit group can be described as a fourth cross-spectrum calculation unit that multiplies the output data of the first FFT and the output data of the fourth FFT for the same complex frequency components after converting one of them into the a conjugate complex number.

The combination of the arrangement of the antenna elements 103 and the cross-spectrum calculation unit group 302 using the technique disclosed in Non-Patent Literature 2 described with reference to Figs. 1 to 4 is a technique for achieving sharp directivity of the phased-array antenna device 101. For this reason, regarding the positional relation between the first antenna element and the second antenna element, the positional relation between the first antenna element and the fourth antenna element, and the like, only the combination of the positions corresponding to the sides of the square-shaped frame 102 illustrated in Fig. 1 has been described. The phased-array antenna device 101 achieves the arrangement of the antenna elements 103 corresponding to the technique in Non-Patent Literature 2 at the positions corresponding to the sides of the frame 102. Therefore, the number of the cross-spectrum calculation unit groups 302 of the above phased-array antenna device 101 is 48 as described above.

Meanwhile, the phased-array antenna device 101 according to the embodiment of the present invention is not limited to the combination of the arrangement of the antenna elements 103 and the cross-spectrum calculation unit group 302 based on the technique disclosed in Non-Patent Literature 2.

If the purpose of the phased-array antenna device 101 is not to achieve a sharp directivity but to obtain reception radio wave signals having various directivities in a short time, the combination of the antenna elements 103 may not be necessarily based on the technique disclosed in Non-Patent Literature 2. For example, it is also possible to provide the cross-spectrum calculation unit group 302 in a combination of the antenna elements 103 in a diagonal arrangement relation in the square-shaped frame 102, as in the positional relation between the second antenna element and the fourth antenna element.

Considering all the combinations of the antenna elements 103 in this manner, in the phased-array antenna device 101 in the present invention, $_{16}C_{15} = (16 \times 15) \div (2 \times 1) = 120$ combinations of the antenna elements 103 can be assumed. Therefore, in the phased-array antenna devices 101 in the present invention, the number of cross-spectrum calculation unit groups 302 is not limited to 48, and 120 cross-spectrum calculation unit groups 302 can be arranged.

In the embodiment of the present invention, the phased-array antenna device 101 has been described.

The phased-array antenna device 101 according to the embodiment of the present invention uses a combination of the antenna elements 103 from which redundancy is eliminated, and directly performs A/D conversion on analog signals over a broad frequency range immediately under the antenna elements 103. At that time, by relatively shifting the supply timing of the sampling clock supplied to the A/D converter according to a desired azimuth with respect to the output analog signals of the two antenna elements 103, a time difference is given to the output digital data obtained from the two antenna elements 103. The time difference is obtained by multiplying the number of steps to shift the sampling clock according to the distance between the two antenna elements 103 by a natural number.

The data output from the A/D converter is converted into complex frequency component data by the FFT 505. The complex frequency component data output from the FFTs 505 of two systems is multiplied after the complex frequency component data output from one of the FFTs 505 is converted into a conjugate complex number by the cross-spectrum calculation unit. The complex frequency component data output from the cross-spectrum calculation unit is added for each of the same time and the same frequency component and then time-integrated to obtain the intensity data of the complex frequency component.

The phased-array antenna device 101 according to the embodiment of the present invention employs a technical approach different from a conventional technique for handling radio waves. Normally, when high-frequency signals based on radio waves obtained from antennas are handled, tuning circuits and down-conversion to intermediate frequencies, and the like, are used. However, the phased-array antenna device 101 according to the embodiment of the present invention does not use a tuning circuit, a PLL, an intermediate frequency, or the like. The signal obtained from the antenna is directly A/D converted after passing through the BPF, and converted into data in a frequency domain by the FFT 505. In this series of analog signal processing, a tuning circuit or the like is not used.

By providing a BPF at a preceding stage of the A/D converter, a signal having a frequency higher than a frequency that can be sampled by the A/D converter is detected using aliasing. In addition, by setting the sampling frequency to an integral multiple of a hexadecimal number, a data sample suitable for the FFT 505 is provided.

As described above, it is possible for the phased-array antenna device 101 according to the embodiment of the present invention to detect weak electromagnetic waves over an extremely broad frequency range for each frequency component with a technical approach and various contrivances greatly different from conventional techniques for wireless communication and microwave radiometers. In addition, since the phased-array antenna device 101 according to the embodiment of the present invention does not use any mechanically movable component, it is obvious that the operating lifespan is longer than those of conventional products.

In addition, since the phased-array antenna device 101 does not need to rotationally be driven, it is possible to easily increase the scale of the device as compared with conventional products. This is advantageous in terms of spatial resolution of antenna devices.

The embodiment of the present invention has been described above, but the present invention is not limited to the above embodiment and includes other modifications and application examples. The scope of protection of the invention is defined in the appended claims.

Reference Signs List

101     Phased-array antenna device

| | |
|---|---|
| 102 | Frame |
| 103 | Antenna element |
| 103a | First-row first-column antenna element |
| 103b | First-row second-column antenna element |
| 103c | First-row third-column antenna element |
| 103d | First-row fourth-column antenna element |
| 103e | Second-row first-column antenna element |
| 103f | Second-row second-column antenna element |
| 103g | Second-row third-column antenna element |
| 103h | Second-row fourth-column antenna element |
| 103i | Third-row first-column antenna element |
| 103j | Third-row second-column antenna element |
| 103k | Third-row third-column antenna element |
| 103l | Third-row fourth-column antenna element |
| 103m | Fourth-row first-column antenna element |
| 103n | Fourth-row second-column antenna element |
| 103o | Fourth-row third-column antenna element |
| 103p | Fourth-row fourth-column antenna element |
| 104 | Front-end unit |
| 104a | First-row first-column front-end unit |
| 104b | First-row second-column front-end unit |
| 104c | First-row third-column front-end unit |
| 104d | First-row fourth-column front-end unit |
| 104o | Fourth-row third-column front-end unit |
| 104p | Fourth-row fourth-column front-end unit |
| 105 | Data processing unit |
| 106 | Clock control unit |
| 201 | Horn antenna element |
| 301 | FFT group |
| 301a | First-row first-column FFT group |
| 301b | First-row second-column FFT group |
| 301c | First-row third-column FFT group |
| 301d | First-row fourth-column FFT group |
| 301o | Fourth-row third-column FFT group |
| 301p | Fourth-row fourth-column FFT group |
| 302 | Cross-spectrum calculation unit group |
| 302a | First cross-spectrum calculation unit group |
| 302b | Second cross-spectrum calculation unit group |
| 302c | Third cross-spectrum calculation unit group |
| 302d | Fourth cross-spectrum calculation unit group |
| 302e | Fifth cross-spectrum calculation unit group |
| 302f | Sixth cross-spectrum calculation unit group |
| 302m | m-th cross-spectrum calculation unit group |
| 303 | Preamplifier |
| 303a | First-row first-column preamplifier |
| 303b | First-row second-column preamplifier |
| 303c | First-row third-column preamplifier |
| 303d | First-row fourth-column preamplifier |
| 303o | Fourth-row third-column preamplifier |
| 303p | Fourth-row fourth-column preamplifier |
| 304a | First-row first-column BPF group |
| 304b | First-row second-column BPF group |
| 304c | First-row third-column BPF group |
| 304d | First-row fourth-column BPF group |
| 304o | Fourth-row third-column BPF group |
| 304p | Fourth-row fourth-column BPF group |
| 305 | A/D converter group |
| 305a | First-row first-column A/D converter group |

| 305b | First-row second-column A/D converter group |
|---|---|
| 305c | First-row third-column A/D converter group |
| 305d | First-row fourth-column A/D converter group |
| 305o | Fourth-row third-column A/D converter group |
| 305p | Fourth-row fourth-column A/D converter group |
| 306 | Register group |
| 306a | First-row first-column register group |
| 306b | First-row second-column register group |
| 306c | First-row third-column register group |
| 306d | First-row fourth-column register group |
| 306o | Fourth-row third-column register group |
| 306p | Fourth-row fourth-column register group |
| 307 | Addition unit |
| 308 | Integration unit |
| 401 | Cross-spectrum calculation group |
| 401a | First cross-spectrum calculation group |
| 401b | Second cross-spectrum calculation group |
| 401c | Third cross-spectrum calculation group |
| 401d | Fourth cross-spectrum calculation group |
| 402 | Cross-spectrum calculation group |
| 402a | Fifth cross-spectrum calculation group |
| 402b | Sixth cross-spectrum calculation group |
| 402c | Sixth cross-spectrum calculation group |
| 402d | Sixth cross-spectrum calculation group |
| 501 | Distributor |
| 502a | First BPF |
| 502b | Second BPF |
| 502c | Third BPF |
| 502d | Fourth BPF |
| 503 | A/D converter |
| 503a | First A/D converter |
| 503b | Second A/D converter |
| 503c | Third A/D converter |
| 503d | Fourth A/D converter |
| 504a | First register |
| 504b | Second register |
| 504c | Third register |
| 504d | Fourth register |
| 505 | FFT |
| 505a | First FFT |
| 505b | Second FFT |
| 505c | Third FFT |
| 505d | Fourth FFT |
| 506 | Cross-spectrum calculation unit |
| 506a | First cross-spectrum calculation unit |
| 506b | Second cross-spectrum calculation unit |
| 506c | Third cross-spectrum calculation unit |
| 506d | Fourth cross-spectrum calculation unit |

## Claims

1. A phased-array antenna device (101) comprising:
   a first antenna element (103a), said phased-array antenna device (101) further comprising:

   a first preamplifier (303a) configured to amplify a signal obtained from the first antenna element;
   a first band pass filted BPF (304a) configured to pass only a signal in a predetermined frequency band from an output signal of the first preamplifier (303a);
   a first analog to digital A/D converter (305a) configured to convert an output signal of the first BPF into digital data;

18

a first FFT (301a) configured to perform a Fourier transform on data output from the first A/D converter;

a second antenna element (103b) arranged apart from the first antenna element by a predetermined distance;

a second preamplifier (303b) that amplifies a signal obtained from the second antenna element;

a second BPF (304b) configured to pass only a signal in the same frequency band as the first BPF from an output signal of the second preamplifier;

a second A/D converter (305b) configured to convert an output signal of the second BPF into digital data;

a second FFT (301b) configured to perform a Fourier transform on data output from the second A/D converter;

a first cross-spectrum calculation unit (302a) configured to multiply output data of the first FFT (301a) and output data of the second FFT (301b) for the same complex frequency component after converting one of the output data of the first FFT and the output data of the second FFT into a conjugate complex number; and

a clock control unit (106) that is configured to supply a sampling clock whose output timing is shifted relative to the first and second A/D converters.

2. The phased-array antenna device (101) according to claim 1, further comprising:

a third antenna element (103c) arranged in a straight line on which the first antenna element (103a) and the second antenna element (103b) are arranged, spaced apart from the second antenna element by a distance that is a natural number multiple of a distance between the first antenna element and the second antenna element;

a third preamplifier (303c) configured to amplify a signal obtained from the third antenna element (103c);

a third BPF (304c) configured to pass only a signal in the same frequency band as the first BPF from an output signal of the third preamplifier;

a third A/D converter (305c) configured to convert an output signal of the third BPF into digital data;

a third FFT (301c) configured to perform a Fourier transform on data output from the third A/D converter;

a second cross-spectrum calculation (302c) unit configured to multiply the output data of the first FFT and output data of the third FFT for the same complex frequency component after converting one of the output data of the first FFT and the output data of the third FFT into a conjugate complex number; and

a third cross-spectrum calculation unit (302b) configured to multiply the output data of the second FFT and output data of the third FFT for the same complex frequency component after converting one of the output data of the second FFT and the output data of the third FFT into a conjugate complex number, wherein

the clock control unit (106) is configured to supply, based on the desired azimuth, a sampling clock whose output timing is relatively shifted to the first A/D converter, the second A/D converter, and the third A/D converter.

3. The phased-array antenna device (101) according to claim 2, further comprising:

a fourth antenna element (103e) arranged in a straight line orthogonal to the straight line on which the first antenna element (103a) and the second antenna element (103b) are arranged and in a straight line intersecting the first antenna element, spaced apart from the first antenna element by a distance that is a natural number multiple of a distance between the first antenna element and the second antenna element;

a fourth preamplifier configured to amplify a signal obtained from the fourth antenna element;

a fourth BPF configured to pass only a signal in the same frequency band as the first BPF from an output signal of the fourth preamplifier;

a fourth A/D converter configured to convert an output signal of the fourth BPF into digital data;

a fourth FFT configured to perform a Fourier transform on data output from the fourth A/D converter; and

a fourth cross-spectrum calculation unit configured to multiply the output data of the first FFT and output data of the fourth FFT for the same complex frequency component after converting one of the output data of the first FFT and the output data of the fourth FFT into a conjugate complex number, wherein

the clock control unit (106) is configured to supply, based on the desired azimuth, a sampling clock whose output timing is relatively shifted to the first A/D converter, and the fourth A/D converter.

4. The phased-array antenna device (101) according to claim 3, further comprising:

a second first BPF configured to pass only a signal in a predetermined frequency band different from the first BPF from an output signal of the first preamplifier;

a second first A/D converter configured to convert an output signal of the first BPF into digital data;

a second first FFT configured to perform a Fourier transform on data output from the second first A/D converter;

a second second BPF configured to pass only a signal in the same frequency band as the second first BPF from an output signal of the second preamplifier;

a second second A/D converter configured to convert an output signal of the second second BPF into digital data;

a second second FFT configured to perform a Fourier transform on data output from the second second A/D converter; and
a second first cross-spectrum calculation unit configured to multiply output data of the second first FFT and output data of the second second FFT for the same complex frequency component after converting one of the output data of the second first FFT and the output data of the second second FFT into a conjugate complex number, wherein

the clock control unit (106) is configured to supply the same sampling clock as the first A/D converter to the second first A/D converter and to supply the same sampling clock as the second A/D converter to the second second A/D converter.

5. The phased-array antenna device (101), according to claim 4, wherein
the clock control unit is configured to generate a sampling clock having a frequency of an integer multiple of the number of a power of two.

**Patentansprüche**

1. Phased-Array-Antennenvorrichtung (101), die Folgendes umfasst:
ein erstes Antennenelement (103a), wobei die Phased-Array-Antennenvorrichtung (101) ferner umfasst:

einen ersten Vorverstärker (303a), der so konfiguriert ist, dass er ein von dem ersten Antennenelement erhaltenes Signal verstärkt;
einen ersten Bandpassfilter BPF (304a), der so konfiguriert ist, dass er nur ein Signal in einem vorgegebenen Frequenzband von einem Ausgangssignal des ersten Vorverstärkers (303a) durchlässt;
einen ersten Analog-Digital-A/D-Wandler (305a), der so konfiguriert ist, dass er ein Ausgangssignal des ersten BPF in digitale Daten umwandelt;
eine erste FFT (301a), die so konfiguriert ist, dass sie eine Fourier-Transformation der vom ersten A/D-Wandler ausgegebenen Daten durchführt;
ein zweites Antennenelement (103b), das in einem vorgegebenen Abstand zum ersten Antennenelement angeordnet ist;
einen zweiten Vorverstärker (303b), der ein von dem zweiten Antennenelement erhaltenes Signal verstärkt;
einen zweiten BPF (304b), der so konfiguriert ist, dass er nur ein Signal im gleichen Frequenzband wie der erste BPF von einem Ausgangssignal des zweiten Vorverstärkers durchlässt;
einen zweiten A/D-Wandler (305b), der so konfiguriert ist, dass er ein Ausgangssignal des zweiten BPF in digitale Daten umwandelt;
eine zweite FFT (301b), die so konfiguriert ist, dass sie eine Fourier-Transformation der vom zweiten A/D-Wandler ausgegebenen Daten durchführt
eine erste Kreuzspektrum-Berechnungseinheit (302a), die so konfiguriert ist, dass sie Ausgabedaten der ersten FFT (301a) und Ausgabedaten der zweiten FFT (301b) für dieselbe komplexe Frequenzkomponente multipliziert, nachdem sie entweder die Ausgabedaten der ersten FFT oder die Ausgabedaten der zweiten FFT in eine konjugiert komplexe Zahl umgewandelt hat; und
eine Taktsteuereinheit (106), die so konfiguriert ist, dass sie einen Abtasttakt liefert, dessen Ausgabezeitpunkt relativ zu dem ersten und zweiten A/D-Wandler verschoben ist.

2. Phased-Array-Antennenvorrichtung (101) nach Anspruch 1, ferner umfassend:

ein drittes Antennenelement (103c), das in einer geraden Linie angeordnet ist, auf der das erste Antennenelement (103a) und das zweite Antennenelement (103b) angeordnet sind, und das von dem zweiten Antennenelement um einen Abstand beabstandet ist, der ein natürliches Vielfaches eines Abstands zwischen dem ersten Antennenelement und dem zweiten Antennenelement ist;
einen dritten Vorverstärker (303c), der so konfiguriert ist, dass er ein von dem dritten Antennenelement (103c) erhaltenes Signal verstärkt;
einen dritten BPF (304c), der so konfiguriert ist, dass er nur ein Signal im gleichen Frequenzband wie der erste BPF von einem Ausgangssignal des dritten Vorverstärkers durchlässt;
einen dritten A/D-Wandler (305c), der so konfiguriert ist, dass er ein Ausgangssignal des dritten BPF in digitale Daten umwandelt;
eine dritte FFT (301c), die so konfiguriert ist, dass sie eine Fourier-Transformation der vom dritten A/D-Wandler ausgegebenen Daten durchführt;

eine zweite Einheit zur Berechnung des Kreuzspektrums (302c), die so konfiguriert ist, dass sie die Ausgabedaten der ersten FFT und die Ausgabedaten der dritten FFT für dieselbe komplexe Frequenzkomponente multipliziert, nachdem sie entweder die Ausgabedaten der ersten FFT oder die Ausgabedaten der dritten FFT in eine konjugiert komplexe Zahl umgewandelt hat; und

eine dritte Kreuzspektrum-Berechnungseinheit (302b), die so konfiguriert ist, dass sie die Ausgabedaten der zweiten FFT und die Ausgabedaten der dritten FFT für dieselbe komplexe Frequenzkomponente multipliziert, nachdem sie entweder die Ausgabedaten der zweiten FFT oder die Ausgabedaten der dritten FFT in eine konjugiert komplexe Zahl umgewandelt hat, wobei

die Taktsteuereinheit (106) so konfiguriert ist, dass sie auf der Grundlage des gewünschten Azimuts einen Abtasttakt liefert, dessen Ausgabezeitpunkt relativ zu dem ersten A/D-Wandler, dem zweiten A/D-Wandler und dem dritten A/D-Wandler verschoben ist.

3. Phased-Array-Antennenvorrichtung (101) nach Anspruch 2, ferner umfassend:

ein viertes Antennenelement (103e), das in einer geraden Linie orthogonal zu der geraden Linie, auf der das erste Antennenelement (103a) und das zweite Antennenelement (103b) angeordnet sind, und in einer geraden Linie, die das erste Antennenelement schneidet, angeordnet ist und von dem ersten Antennenelement um einen Abstand beabstandet ist, der ein natürliches Vielfaches eines Abstands zwischen dem ersten Antennenelement und dem zweiten Antennenelement ist;

einen vierten Vorverstärker, der so konfiguriert ist, dass er ein von dem vierten Antennenelement erhaltenes Signal verstärkt;

einen vierten BPF, der so konfiguriert ist, dass er nur ein Signal im gleichen Frequenzband wie der erste BPF von einem Ausgangssignal des vierten Vorverstärkers durchlässt;

einen vierten A/D-Wandler, der so konfiguriert ist, dass er ein Ausgangssignal des vierten BPF in digitale Daten umwandelt;

eine vierte FFT, die so konfiguriert ist, dass sie eine Fourier-Transformation der vom vierten A/D-Wandler ausgegebenen Daten durchführt; und

eine vierte Kreuzspektrum-Berechnungseinheit, die so konfiguriert ist, dass sie die Ausgabedaten der ersten FFT und die Ausgabedaten der vierten FFT für die gleiche komplexe Frequenzkomponente multipliziert, nachdem sie entweder die Ausgabedaten der ersten FFT oder die Ausgabedaten der vierten FFT in eine konjugiert komplexe Zahl umgewandelt hat, wobei

die Taktsteuereinheit (106) so konfiguriert ist, dass sie auf der Grundlage des gewünschten Azimuts einen Abtasttakt liefert, dessen Ausgabezeitpunkt relativ zu dem ersten A/D-Wandler und dem vierten A/D-Wandler verschoben ist.

4. Phased-Array-Antennenvorrichtung (101) nach Anspruch 3, ferner umfassend:

einen zweiten ersten BPF, der so konfiguriert ist, dass er von einem Ausgangssignal des ersten Vorverstärkers nur ein Signal in einem vorbestimmten Frequenzband durchlässt, das sich vom ersten BPF unterscheidet;

einen zweiten ersten A/D-Wandler, der so konfiguriert ist, dass er ein Ausgangssignal des ersten BPF in digitale Daten umwandelt;

eine zweite erste FFT, die so konfiguriert ist, dass sie eine Fourier-Transformation der vom zweiten ersten A/D-Wandler ausgegebenen Daten durchführt;

einen zweiten econd BPF, der so konfiguriert ist, dass er nur ein Signal im gleichen Frequenzband wie der zweite erste BPF von einem Ausgangssignal des zweiten Vorverstärkers durchlässt;

einen zweiten zweiten A/D-Wandler, der so konfiguriert ist, dass er ein Ausgangssignal des zweiten BPF in digitale Daten umwandelt;

eine zweite FFT, die so konfiguriert ist, dass sie eine Fourier-Transformation der vom zweiten A/D-Wandler ausgegebenen Daten durchführt; und

eine zweite erste Kreuzspektrum-Berechnungseinheit, die so konfiguriert ist, dass sie Ausgabedaten der zweiten ersten FFT und Ausgabedaten der zweiten zweiten FFT für die gleiche komplexe Frequenzkomponente multipliziert, nachdem sie entweder die Ausgabedaten der zweiten ersten FFT oder die Ausgabedaten der zweiten zweiten FFT in eine konjugiert komplexe Zahl umgewandelt hat, wobei

die Taktsteuereinheit (106) so konfiguriert ist, dass sie denselben Abtasttakt wie der erste A/D-Wandler an den zweiten ersten A/D-Wandler und denselben Abtasttakt wie der zweite A/D-Wandler an den zweiten zweiten A/D-Wandler liefert.

**5.** Phased-Array-Antennenvorrichtung (101) nach Anspruch 4, wobei
die Taktsteuerungseinheit so konfiguriert ist, dass sie einen Abtasttakt mit einer Frequenz eines ganzzahligen Vielfachen der Zahl einer Zweierpotenz erzeugt.

**Revendications**

**1.** Un dispositif d'antenne (101) à réseau phasé, comprenant :

un premier élément d'antenne (103a), ledit dispositif d'antenne (101) à réseau phasé, comprenant de plus ;
un premier préamplificateur (303a), configuré pour amplifier un signal obtenu à partir du premier élément d'antenne ;
un premier filtre de bande passante, BPF, (304a), configuré pour laisser passer uniquement un signal dans une bande de fréquence prédéterminée à partir d'un signal de sortie du premier préamplificateur (303a) ;
un premier convertisseur analogique-numérique, A/N, (305a), configuré pour convertir un signal de sortie du premier BPF en données numériques ;
une première FFT (301a), configurée pour effectuer une transformée de Fourier sur la sortie de données du premier convertisseur A/N ;
un deuxième élément d'antenne (103b), agencé à l'écart du premier élément d'antenne d'une distance prédéterminée ;
un deuxième préamplificateur (303b), qui amplifie un signal obtenu à partir du deuxième élément d'antenne ;
un deuxième BPF (304b), configuré pour laisser passer uniquement un signal dans la même bande de fréquence que le premier BPF à partir d'un signal de sortie du deuxième préamplificateur ;
un deuxième convertisseur A/N (305b), configuré pour convertir un signal de sortie du deuxième BPF en données numériques ;
une deuxième FFT (301b), configurée pour effectuer une transformée de Fourier sur les données de sortie provenant du deuxième convertisseur A/N ;
une première unité (302a) de calcul de spectre croisé, configurée pour multiplier les données de sortie de la première FFT (301a) et les données de sortie de la deuxième FFT (301b) pour la même composante de fréquence complexe après avoir converti soit les données de sortie de la première FFT, soit les données de sortie de la deuxième FFT en un nombre complexe conjugué ; et
une unité (106) de commande d'horloge qui est configurée pour fournir une horloge d'échantillonnage dont la synchronisation de sortie est décalée par rapport aux premier et deuxième convertisseurs A/N.

**2.** Le dispositif d'antenne (101) à réseau phasé selon la revendication 1, comprenant en outre :

un troisième élément d'antenne (103c), agencé sur une ligne droite sur laquelle sont agencés le premier élément d'antenne (103a) et le deuxième élément d'antenne (103b), espacé du deuxième élément d'antenne d'une distance qui est un multiple naturel d'une distance entre le premier élément d'antenne et le deuxième élément d'antenne ;
un troisième préamplificateur (303c), configuré pour amplifier un signal obtenu à partir du troisième élément d'antenne (103c) ;
un troisième BPF (304c), configuré pour laisser passer uniquement un signal dans la même bande de fréquence que le premier BPF à partir d'un signal de sortie du troisième préamplificateur ;
un troisième convertisseur A/N (305c), configuré pour convertir un signal de sortie du troisième BPF en données numériques ;
une troisième FFT (301c), configurée pour effectuer une transformée de Fourier sur les données de sortie provenant du troisième convertisseur A/N ;
une deuxième unité (302c) de calcul de spectre croisé, configurée pour multiplier les données de sortie de la première FFT et les données de sortie de la troisième FFT pour la même composante de fréquence complexe après conversion soit des données de sortie de la première FFT, soit des données de sortie de la troisième FFT en un nombre complexe conjugué ; et
une troisième unité (302b) de calcul de spectre croisé, configurée pour multiplier les données de sortie de la deuxième FFT et les données de sortie de la troisième FFT pour la même composante de fréquence complexe après conversion soit des données de sortie de la deuxième FFT, soit des données de sortie de la troisième FFT en un nombre complexe conjugué,
l'unité (106) de commande d'horloge étant configurée pour fournir, sur la base de l'azimut souhaité, une horloge d'échantillonnage dont la synchronisation de sortie est relativement décalée par rapport au premier convertisseur A/N, au deuxième convertisseur A/N et au troisième convertisseur A/N.

3. Le dispositif d'antenne (101) à réseau phasé selon la revendication 2, comprenant en outre :

un quatrième élément d'antenne (103e) agencé sur une ligne droite orthogonale à la ligne droite sur laquelle sont agencés le premier élément d'antenne (103a) et le deuxième élément d'antenne (103b) et sur une ligne droite croisant le premier élément d'antenne, espacé du premier élément d'antenne d'une distance qui est un multiple naturel d'une distance entre le premier élément d'antenne et le deuxième élément d'antenne ;
un quatrième préamplificateur configuré pour amplifier un signal obtenu à partir du quatrième élément d'antenne ;
un quatrième BPF configuré pour laisser passer uniquement un signal dans la même bande de fréquence que le premier BPF à partir d'un signal de sortie du quatrième préamplificateur ;
un quatrième convertisseur A/N configuré pour convertir un signal de sortie du quatrième BPF en données numériques ;
une quatrième FFT configurée pour effectuer une transformée de Fourier sur la sortie de données du quatrième convertisseur A/N ; et
une quatrième unité de calcul de spectre croisé configurée pour multiplier les données de sortie de la première FFT et les données de sortie de la quatrième FFT pour la même composante de fréquence complexe après conversion de l'une parmi les données de sortie de la première FFT et les données de sortie de la quatrième FFT en un nombre complexe conjugué,
l'unité (106) de commande d'horloge étant configurée pour fournir, sur la base de l'azimut souhaité, une horloge d'échantillonnage dont la synchronisation de sortie est relativement décalée par rapport au premier convertisseur A/N et au quatrième convertisseur A/N.

4. Le dispositif d'antenne (101) à réseau phasé selon la revendication 3, comprenant en outre :

un deuxième premier BPF configuré pour laisser passer uniquement un signal dans une bande de fréquence prédéterminée différente du premier BPF à partir d'un signal de sortie du premier préamplificateur ;
un deuxième premier convertisseur A/N configuré pour convertir un signal de sortie du premier BPF en données numériques ;
une deuxième première FFT configurée pour effectuer une transformée de Fourier sur les données de sortie du deuxième premier convertisseur A/N ;
un deuxième deuxième BPF configuré pour laisser passer uniquement un signal dans la même bande de fréquence que le deuxième premier BPF à partir d'un signal de sortie du deuxième préamplificateur ;
un deuxième deuxième convertisseur A/N configuré pour convertir un signal de sortie du deuxième deuxième BPF en données numériques ;
une deuxième deuxième FFT configurée pour effectuer une transformée de Fourier sur les données de sortie du deuxième deuxième convertisseur A/N ; et
une deuxième première unité de calcul de spectre croisé configurée pour multiplier les données de sortie de la deuxième première FFT et les données de sortie de la deuxième deuxième FFT pour la même composante de fréquence complexe après conversion soit des données de sortie de la deuxième première FFT, soit des données de sortie de la deuxième deuxième FFT en un nombre complexe conjugué,
l'unité (106) de commande d'horloge étant configurée pour fournir la même horloge d'échantillonnage que le premier convertisseur A/N au deuxième premier convertisseur A/N et pour fournir la même horloge d'échantillonnage que le deuxième convertisseur A/N au deuxième deuxième convertisseur A/N.

5. Le dispositif d'antenne (101) à réseau phasé, selon la revendication 4, dans lequel
l'unité de commande d'horloge est configurée pour générer une horloge d'échantillonnage ayant une fréquence d'un multiple entier du nombre d'une puissance de deux.

FIG. 1    <u>101</u>

*FIG. 2*

103

*FIG. 3*

FIG. 4

FIG. 5

*FIG. 6A*

1 SECOND

t

*FIG. 6B*

1 SECOND: 16.384 × 10⁹ PIECES (∵16.384 GSPS)

t

*FIG. 6C*

0 to 8192 MHz: 8.192 × 10⁹ PIECES (512 × 16 × 10⁶)

REAL PART
IMAGINARY PART

REAL PART
IMAGINARY PART

512 PIECES  512 PIECES          512 PIECES  512 PIECES

16 × 10⁶ SETS

0sec      62.5nsec          1sec–        1sec
                           62.5nsec          t

*FIG. 6D*

512 PIECES  ×  512 PIECES

REAL PART
IMAGINARY PART

MULTIPLICATION  MULTIPLICATION     MULTIPLICATION  MULTIPLICATION

REAL PART
IMAGINARY PART
(CONJUGATE
COMPLEX NUMBER)

0Hz      16MHz          8176MHz  8192MHz        f

## FIG. 7E

0 to 8192 MHz: $8.192 \times 10^9$ PIECES ($512 \times 16 \times 10^6$)

REAL PART
IMAGINARY PART

REAL PART
IMAGINARY PART

512 PIECES · 512 PIECES · · · · · 512 PIECES · 512 PIECES

$16 \times 10^6$ SETS

0sec    62.5nsec    1sec− 62.5nsec    1sec    t

## FIG. 7F

512 PIECES · 512 PIECES · · · · 512 PIECES · 512 PIECES

512 PIECES · 512 PIECES · · · · 512 PIECES · 512 PIECES

512 PIECES · 512 PIECES · · · · 512 PIECES · 512 PIECES

ADDITION    ADDITION    ADDITION    ADDITION

0sec    62.5nsec    1sec− 62.5nsec    1sec    t

30

# FIG. 8G

REAL PART
IMAGINARY PART

ADDITION  ADDITION          ADDITION  ADDITION

REAL PART
IMAGINARY PART

0Hz      16MHz              8176MHz   8192MHz

# FIG. 8H

0 to 8192 MHz: $8.192 \times 10^9$ PIECES ($512 \times 16 \times 10^6$)

REAL PART
IMAGINARY PART

REAL PART
IMAGINARY PART

$16 \times 10^6$ SETS

0sec   62.5nsec           1sec−      1sec
                          62.5nsec

# FIG. 9I

16 × 10⁶ SETS

1 SET

REAL PART→

IMAGINARY→
PART

REAL PART→

IMAGINARY→
PART

REAL PART→

IMAGINARY→
PART

REAL PART→

IMAGINARY→
PART

f

Σ

Σ

Σ

Σ

0Hz

16MHz

8176
MHz

8192
MHz

f

512 PIECES    512 PIECES    512 PIECES    512 PIECES        512 PIECES

0sec    62.5nsec    1sec−
62.5nsec    1sec    t

CORRELATION FUNCTION $x = \int_0^T G_1 v_0(t) G_2 v_0(t - \tau) dt$

P1001

P1003

P1002

$\tau$

RECEPTION SIGNAL OF
ELEMENT 2 (DOTTED LINE)
$G_2 v_0(t - \tau)$

RECEPTION SIGNAL OF
ELEMENT 1 (SOLID LINE)
$G_1 v_0(t)$

$\tau$

$t$

$\tau$

$t$

*FIG. 10*

EP 4 075 152 B1

**FIG. 11A**

AZIMUTH[° ]

0

**FIG. 11B**

AZIMUTH[° ]

0

34

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H7209359 A

- US 5874916 A

**Non-patent literature cited in the description**

- *Space utilization by artificial satellites: Global Change Observation Mission - Water "Shizuku" (GCOM-W)*, http://www.jaxa.jp/projects/sat/gcom_w

- **ADRIANO CAMPS** ; **ANGEL CARDAMA** ; **D. INFANTES**. Synthesis of Large Low-Redundancy Linear Arrays. *IEEE TRANSACTIONS ON ANTENNAS AND PROPAGATION*, December 2002, vol. 49, https://www.semanticscholar.org/paper/Synthesis-of-large-low-redundancy-linear-arrays-Camps-Cardama/f8a1e40005ce0491066d945d808bae0c7abd4a7b